# EUROPÄISCHE PATENTANMELDUNG

(11) **EP 3 627 545 A2**
(43) Veröffentlichungstag der Anmeldung: **25.03.2020**
(21) Anmeldenummer: 19187651.5
(22) Anmeldetag: 22.07.2019
(51) Int. Cl.: H01L 23/055, G02B 6/42, H01L 23/10, H01S 5/022, H01L 23/045

(54) **TO-GEHÄUSE MIT EINEM ERDANSCHLUSS**

(30) Priorität: 27.08.2018 DE 102018120895
(71) Anmelder: SCHOTT AG, 55122 Mainz (DE)
(72) Erfinder: HETTLER, Robert, 84036 Kumhausen (DE); AOWUDOMSUK, Artit, Bangkok 10210 (TH); TAN, Kenneth, Singapur 400035 (SG); DRÖGEMÜLLER, Kartsten, 82223 Eichenau (DE)
(74) Vertreter: Blumbach · Zinngrebe Patentanwälte PartG mbB

(57) **Zusammenfassung**

TO-Gehäuse (1), umfassend einen Sockel (2) mit einer Oberseite (21), welche nach Anbringen einer Kappe (3) eine Innenwand des dann hermetisch verschlossenen TO-Gehäuses (1) bildet, und einer Unterseite (14), und mit einem Montagebereich (30) für ein optoelektronisches Bauelement, wobei der Sockel (2) zumindest einen in einer Durchführung (9) angeordneten Signalpin (7, 7a, 7b) zum Anschluss des optoelektronischen Bauelements umfasst. Dabei ist eine Leiterplatte (12) im Wesentlichen koaxial an dem Signalpin (7, 7a, 7b) angebracht und die Leiterplatte (12) ist mittels zumindest eines an die Durchführung (9) angrenzenden Metallblocks (13) mit dem Sockel (2) mechanisch und elektrisch zur Bereitstellung einer Erdung verbunden. Beschrieben ist des Weiteren ein TO-Gehäuse (1), welches einen Signalpin (7, 7a, 7b) mit einer Verdickung (19, 19a, 19b) umfasst, welche in einer Ebene mit dem Boden des Sockels (2) liegt oder in das Gehäuse hineinragt.

## Beschreibung

Die Erfindung betrifft ein TO (Transistor Outline)-Gehäuse sowie ein Verfahren zu dessen Herstellung.

### Hintergrund der Erfindung

TO-Gehäuse mit eingeglasten Signalpins sind bekannt. Ein derartiges TO-Gehäuse umfasst in der Regel einen Sockel aus Metall, durch den zumindest ein Signalpin geführt ist, welcher in einer Glasdurchführung sitzt. Über den Signalpin kann ein optoelektronisches Bauelement, insbesondere eine Laserdiode, kontaktiert werden. Über derartige Glasdurchführungen, insbesondere eingeschmolzene Glasdurchführungen, lassen sich auf einfache Weise hermetisch abgedichtete Gehäuse mit hoher Temperaturbeständigkeit bereitstellen.

Derzeit sind Datenübertragungsraten von 25 GBit/s pro Kanal beim 100 G Internetstandard üblich. Um den nächsten Internetstandard 400 G zu erreichen, muss die Datenübertragungsrate in etwa verdoppelt werden, um etwa 100 GBit/s pro Wellenlänge zu erreichen.

Dies erfordert gleichzeitig die Verdopplung der Bandbreite sowie der Übertragungsfrequenz.

Der Bereich der Glasdurchführungen eines TO-Gehäuses ist problematisch, weil es aufgrund des Isolationsmaterials aus Glas, welches eine andere Permittivität als Luft hat, immer zu einem Sprung in der Impedanz der Signalleitung kommt. Ein derartiger Impedanzsprung kann beispielsweise durch einen Überstand des Signalpins auf der Unterseite des Gehäuses kompensiert werden.

Nachteilig bei aus der Praxis bekannten TO-Gehäusen ist, insbesondere wenn diese über zwei Signalpins verfügen, die geringe Toleranz gegenüber Form- und Lagetoleranzen der Pins. Insbesondere eingeglaste Pins können Lagetoleranzen, wie beispielsweise einem Winkelversatz des Pins, in der Durchführung unterliegen.

Dies auszugleichen ist schwierig, sofern gleichzeitig in einem Prozessschritt ein Pin zur Bereitstellung einer Erdverbindung angeschlossen werden soll.

### Aufgabe der Erfindung

Der Erfindung liegt demgegenüber die Aufgabe zugrunde, die genannten Nachteile des Standes der Technik zu reduzieren. Es ist insbesondere eine Aufgabe der Erfindung, ein besser montierbares TO-Gehäuse bereitzustellen, welches höhere Datenübertragungsraten ermöglicht, sowie Verwendungen eines solchen TO-Gehäuses.

### Zusammenfassung der Erfindung

Die Aufgabe der Erfindung wird bereits durch ein TO-Gehäuse nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft ein TO-Gehäuse. Dieses umfasst einen Sockel mit einer Oberseite, welche nach Anbringen einer Kappe eine Innenwand des dann hermetisch verschlossenen TO-Gehäuses bildet, und einer Unterseite, und mit einem Montagebereich für ein optoelektronisches Bauelement im Innenraum des TO-Gehäuses.

In der Regel besteht das fertig montierte Gehäuse aus einem Sockel, welcher vorzugsweise aus Metall besteht, auf den eine Kappe, die vorzugsweise ebenfalls aus Metall besteht und ein Fenster aufweist, aufgebracht, insbesondere aufgelötet, ist.

In dem so gebildeten Innenraum wird der Montagebereich für das optoelektronische Bauelement bereitgestellt.

Das TO-Gehäuse ist hermetisch verschlossen und weist zumindest einen in einer Durchführung angeordneten Signalpin, der aus der Unterseite herausragt, zum Anschluss des elektronischen Bauelements auf.

Über den Signalpin wird das optoelektronische Bauelement, welches insbesondere als Laserdiode ausgebildet ist, angesteuert oder ausgelesen. Die Erfindung bezieht sich insbesondere auf optoelektronische Bauelemente, wobei das TO-Gehäuse zwei Signalpins aufweist, die vorzugsweise jeweils in einer Durchführung sitzen.

Aufgrund der hohen Datenübertragungsraten und der damit verbundenen hohen Übertragungsfrequenz ist ein gleichmäßiger Impedanzverlauf des Signalpfades, welcher u.a. die Durchführung umfasst, wichtig.

Gemäß einem Aspekt der Erfindung ist eine Leiterplatte im Wesentlichen koaxial an dem Signalpin angebracht, wobei die Leiterplatte mittels zumindest eines an die Durchführung angrenzenden Metallblocks mit dem Sockel mechanisch und elektrisch zur Bereitstellung einer Erdung verbunden ist.

Im Unterschied zu den meisten aus der Praxis bekannten TO-Gehäusen ist die Leiterplatte also nicht senkrecht mit dem Signalpin verbunden, sondern koaxial zum Signalpin angeordnet.

Weiter ist statt eines Pins zur Bereitstellung einer Erdverbindung ein Metallblock vorgesehen, welcher einen Winkel, insbesondere einen rechten Winkel, bereitstellt und so die Leiterplatte, insbesondere eine Erdleiterbahn der Leiterplatte, mit der Unterseite des Sockels mechanisch und elektrisch verbindet.

Neben der mechanischen Verbindung und der elektrischen Erdverbindung wird durch den Metallblock eine Schirmung des angrenzenden, aus der Durchführung herausragenden Signalpins bereitgestellt.

Vorzugsweise steht der Signalpin nicht über den Metallblock heraus.

Der Metallblock ist insbesondere als eine Platte ausgebildet.

Vorzugsweise hat der Metallblock eine Dicke von über 0,1 mm, besonders bevorzugt über 0,5 mm und/oder von unter 5 mm, besonders bevorzugt von unter 2 mm.

Der Metallblock kann sich über einen großen Teil des Durchmessers des Sockels erstrecken, insbesondere über zumindest 20 %, vorzugsweise über zumindest 50 % des Durchmessers des Sockels.

Neben der Schirmung und stabileren mechanischen Anbindung der Leiterplatte wird durch die Verwendung des Metallblocks ferner das Anlöten der oder des Signalpins vom Bereitstellen einer Erdverbindung entkoppelt.

So können Lagetoleranzen der Signalpins besser ausgeglichen werden und es kann im Anschluss die Erdverbindung durch Anlöten des Metallblocks an der Leiterplatte und/oder an der Unterseite des Sockels vorgenommen werden, wobei aufgrund der vorzugsweise plattenförmigen Ausgestaltung des Metallblocks Form- und Lagetoleranzen keine große Rolle spielen.

Der Metallblock ist insbesondere als massive Platte aus Metall ausgebildet.

Denkbar ist aber auch die Verwendung eines dielektrischen Materials, welches mit einer Metallschicht versehen ist.

Bei einer bevorzugten Ausführungsform der Erfindung ist der Metallblock als Brücke ausgebildet, die sich über den in der Durchführung angeordneten Signalpin erstreckt. Es ist insbesondere vorgesehen, dass die Brücke zwei Bögen aufweist, die sich jeweils über einen Signalpin erstrecken. So kann eine optimale Schirmung des aus dem Boden des Sockels herausragenden Signalpins bereitgestellt werden.

Bei einer alternativen Ausführungsform der Erfindung ist aber auch denkbar, statt eines einzelnen Metallblocks mehrere Metallblöcke zu verwenden, welche jeweils randseitig an den Signalpin angrenzen.

Die Leiterplatte ist vorzugsweise als flexible Leiterplatte ausgebildet. So kann diese beispielsweise gewinkelt, um beispielsweise 90°, gebogen werden, um an einem elektronischen Modul angeschlossen zu werden.

Bei einer Weiterbildung der Erfindung ist die Metallplatte unterhalb des Metallblocks mit einer Versteifung versehen. Die Versteifung liegt im montierten Zustand unterhalb des Metallblocks und stabilisiert so die Leiterplatte. Es ist so insbesondere auf einfache Weise möglich, eine flexible Leiterplatte mit guter mechanischer Stabilität mit dem Metallblock zu verbinden.

Die Leiterplatte ist vorzugsweise als mehrlagige Platte (multi-layer board) ausgebildet, wobei unter einer Signalleiterbahn und/oder zwischen den Signalleiterbahnen ein Erdleiter vorhanden ist.

Vorzugsweise umfasst das TO-Gehäuse zumindest zwei, vorzugsweise genau zwei, jeweils in einer Durchführung angeordnete Signalpins.

Der Montagebereich befindet sich vorzugsweise auf einem Submount, der über zumindest einen Signalpin, vorzugsweise über zwei Signalpins, kontaktiert ist.

Der Submount besteht vorzugsweise aus einem dielektrischen Material, insbesondere einer Keramik, insbesondere aus Aluminiumoxid oder Aluminiumnitrit, oder aus Glas oder Silizium.

Vorzugsweise sitzt der Submount auf einem Podest des Sockels. Der Podest kann beispielsweise einstückig mit dem restlichen Sockel ausgebildet sein oder als separates Teil an dem Sockel montiert werden.

Insbesondere kann der Sockel mit dem Podest als Stanzteil aus Metall ausgebildet sein.

Vorzugsweise besteht der Sockel aus Metall und ist mit einer Beschichtung, insbesondere mit einer Beschichtung aus Gold, versehen.

Bei einer bevorzugten Ausführung des erfindungsgemäßen TO-Gehäuses grenzt der Signalpin an einen Submount für das optoelektronische Bauelement an, wobei der Signalpin exzentrisch in der Durchführung in Richtung des Submounts versetzt angeordnet ist.

Gemäß einer Weiterbildung der Erfindung ist die Durchführung des Signalpins mit einem Isolationsmaterial aus Glas und/oder Glaskeramik gefüllt, wobei sich auf zumindest einer Seite der Durchführung ein Bereich befindet, in welchem die Durchführung nicht mit dem Isolationsmaterial aus Glas und/oder Glaskeramik ausgespart befüllt ist. Das Isolationsmaterial aus Glas und/oder Glaskeramik ist also von der Ober- und/oder Unterseite des Sockels beabstandet.

Es hat sich herausgestellt, dass dadurch, dass die Durchführung nur teilweise mit dem Isolationsmaterial aus Glas und/oder Glaskeramik gefüllt wird, es so möglich ist, den Einfluss von Schwankungen im Füllvolumen zu minimieren.

Insbesondere kann eine Meniskusbildung, vor allem eine Meniskusbildung über die Unter- bzw. Oberseite des Sockels hinaus und/oder entlang des Signalpins, weitgehend vermieden werden.

Im ausgesparten Bereich kann der Signalpin eine Verdickung aufweisen. Die Verdickung kann insbesondere als Kragen ausgebildet sein.

Hierdurch ist eine Impedanzanpassung möglich, da der dickere Kragen die geringere Permittivität im ausgesparten Bereich zumindest teilweise kompensiert.

Weiter ist gemäß einer Ausführungsform der Erfindung vorgesehen, dass der Bereich der Durchführung, in welchem kein Isolationsmaterial aus Glas und/oder Glaskeramik vorhanden ist, mit einem Kunststoff, insbesondere mit einem Epoxidharz, aufgefüllt ist.

Prozesstechnisch ist eine Auffüllung mit einem Kunststoff, welcher beispielsweise thermisch oder mittels Licht gehärtet werden kann, einfacher möglich, ohne dass die Gefahr besteht, dass der Kunststoff über die Durchführung hinausragt.

Vorzugsweise wird ein Isolationsmaterial aus Glas und/oder Glaskeramik mit einer niedrigen relativen Permittivität εᵣ (bei 18°C und 50 Hz) von unter 6,0, vorzugsweise von unter 5,0, verwendet.

Gemäß einer anderen Ausführungsform wird ein Glas oder eine Glaskeramik verwendet, das bzw. die eine höhere Permittivität, insbesondere eine Permittivität εᵣ zwischen 5,0 und 8, vorzugsweise zwischen 6,5 und 7 hat. Derartige Gläser eignen sich insbesondere für Druckglasdurchführungen, also Durchführungen, bei denen das Glas unter einer thermisch induzierten mechanischen Druckspannung steht.

Vorzugsweise ist die Permittivität des optional in den nicht mit Glas und/oder Glaskeramik befüllten Bereich eingebrachten Kunststoff dem des Glases angepasst, insbesondere entspricht die Permittivität εᵣ des Kunststoffes der des Isolationsmaterials aus Glas +/- 1,0.

Gemäß einer Ausführungsform der Erfindung kann die Leiterplatte angrenzend zur Unterseite des TO-Gehäuses verdickt ausgebildet sein.

Es ist insbesondere vorgesehen, dass der verdickte Bereich der Leiterplatte als mehrlagige, insbesondere starre Leiterplatte ausgebildet ist, welche in eine flexible Leiterplatte übergeht.

Über den verdickten, mehrlagigen Bereich können weitere Anschlüsse, beispielsweise für eine Monitor-Diode bereitgestellt werden.

Weiter kann der verdickte Bereich gleichzeitig die vorstehend beschriebene Versteifung ausbilden.

Die Erfindung betrifft des Weiteren ein Set zur Bereitstellung des vorstehend beschriebenen TO-Gehäuses.

Dieses umfasst zumindest einen Sockel mit zumindest einem in einer Durchführung angeordneten Signalpin sowie einen Metallblock zum Verbinden des Sockels mit einer Leiterplatte.

Der Metallblock ist kann bereits im ausgelieferten Zustand mit der Leiterplatte verbunden sein oder als separates Bauteil mitgeliefert sein.

Gemäß einer weiteren Ausführungsform der Erfindung ist der Metallblock einstückig mit dem Sockel ausgebildet, insbesondere als einstückiges Stanzteil.

Durch die Entkopplung von Anlöten der Signalpins und Bereitstellen der Erdverbindung können Lagertoleranzen der Signalpins besonders einfach kompensiert werden.

Dementsprechend betrifft die Erfindung auch ein Verfahren zur Montage eines vorstehend beschriebenen TO-Gehäuses, wobei zunächst der zumindest eine Signalpin mit der Leiterplatte verbunden wird und im Anschluss der Metallblock mit Sockel und Leiterplatte zur Bereitstellung einer Erdverbindung verbunden wird.

Die Erfindung betrifft des Weiteren ein TO-Gehäuse, welches insbesondere, wie vorstehend beschrieben, ausgestaltet sein kann und/oder welches neben den nachfolgend beschriebenen Merkmalen weitere einzelne Merkmale des vorstehend beschriebenen TO-Gehäuses umfassen kann.

Das TO-Gehäuse umfasst einen Sockel mit einem Montagebereich für ein optoelektronisches Bauelement.

Weiter umfasst der Sockel einen in einer Durchführung angeordneten Signalpin zum Anschuss des optoelektronischen Bauelements. Die Durchführung ist insbesondere mit einem Isolationsmaterial, welches Glas und/oder Glaskeramik umfasst, befüllt.

Wie vorstehend beschrieben, wird so eine hermetisch verschlossene elektronische Durchführung bereitgestellt.

Gemäß der Erfindung umfasst der Signalpin eine Verdickung, welche zumindest abschnittsweise in der Durchführung angeordnet ist.

Gemäß einer Ausführungsform der Erfindung liegt die Verdickung im Wesentlichen in einer Ebene mit dem an die Durchführung angrenzenden Boden des Sockels.

Hierunter wird verstanden, dass die Verdickung, welche beispielsweise kreiszylindrisch ausgebildet sein kann, im Wesentlichen auf Höhe des Bodens des Sockels endet. Die gehäuseinnenseitige Stirnseite der Verdickung liegt also auf einer Ebene mit dem angrenzenden Boden des Sockels.

Es versteht sich, dass eine gewisse Toleranz hinsichtlich der Höhe der Verdickung möglich ist. So wird im Sinne der Erfindung ein Höhenversatz von +/- 0,5 mm, vorzugsweise von +/- 0,2 mm noch als in einer Ebene liegend verstanden.

Insbesondere eine maximal 0,5 mm, vorzugsweise maximal 0,2 mm höher liegende Verdickung kann fertigungstechnische Vorteile haben, da z.B. die Verdickung vor dem Einglasen in einem Halter sitzen kann.

Gemäß einer anderen Ausführungsform der Erfindung kann die Verdickung auch in das Gehäuse überstehen. Dies kann zwar eine stirnseitige Kontaktierung erschweren.

Entscheidend ist aber, dass wie nachstehend im Detail ausgeführt, durch die Verdickung die Spaltbreite im Bereich des Bodens des Sockels reduziert und/oder die Leiterbahnen des Submounts überhaupt stirnseitig an der Verdickung angeschlossen werden können.

Gemäß einer bevorzugten Ausführungsform der Erfindung ist der Signalpin mit einem elektrisch leitenden Material mit einem Submount, bzw. der Leiterbahn eines Submount, verbunden. Als elektrisch leitendes Material wird insbesondere ein Lot verwendet. Alternativ kann auch ein elektrisch leitender Kunststoff, z.B. ein leitendes Epoxidharz, verwendet werden

Der Signalpin ist durch die elektrische leitende Masse flächig mit der Leiterbahn des Submounts verbunden. Es wird also kein Bonddraht zum Kontaktieren des Submounts verwendet.

Hierdurch wird eine mechanisch stabile Verbindung bereitgestellt und gleichzeitig werden Schwankungen in der Impedanz reduziert.

Zum Kontaktieren des Signalpins sind zwei bevorzugte Ausführungsformen vorgesehen.

Gemäß einer ersten Ausführungsform der Erfindung ist der Signalpin an einer Seitenwand mit dem Submount verbunden.

Hierzu kann insbesondere der Signalpin einen an die Verdickung angrenzenden Überstand aufweisen. Der Überstand ist seitlich mit dem Signalpin verbunden. Der Überstand bildet so eine Lötfahne.

Gemäß einer anderen Ausführungsform der Erfindung ist der Signalpin stirnseitig kontaktiert. Bei dieser Ausführungsform der Erfindung endet der Signalpin vorzugsweise mit der Verdickung. Der Signalpin ist also im Längsschnitt T-förmig ausgebildet.

Vorzugsweise ist zumindest die gehäuseinnenseitige Stirnseite der Verdickung eben ausgebildet.

Der Boden des Sockels liegt beim mit einer Kappe versehenen TO-Gehäuse im Inneren des TO-Gehäuses.

Bei der Montage des optoelektronischen Bauelements kann ein Submount auf den Boden aufgesetzt werden.

Es ist insbesondere vorgesehen, dass der Submount auf ein Podest gesetzt wird, welches sich vom Boden ausgehend quer in das TO-Gehäuse erstreckt.

Durch die Verdickung, welche im Wesentlichen mit dem Boden fluchtet, wird es ermöglicht, dass ein Submount teilweise über der Verdickung liegt. Hierdurch kann gegenüber einem seitlich neben dem Signalpin liegenden Submount die Breite eines Spalts zwischen einer Signalleiterbahn des Submounts und dem Anschlussbereich des Signalpins reduziert werden und/oder die Varianz der Spaltbreite aufgrund von Bauteiltoleranzen verringert werden.

Es kann weniger Lot verwendet werden und die Streuung des Widerstandswerts des Lötbereichs nimmt ab.

Durch diese Ausgestaltung kann weiterhin die Reflexionsdämpfung verbessert werden.

Der Submount, insbesondere zumindest eine Leiterbahn des Submount, kann insbesondere direkt an die Stirnseite der Verdickung angrenzen.

Die Erfindung betrifft des Weiteren ein TO-Gehäuse, insbesondere mit einem oder mehrerer vorstehend beschriebener Merkmale.

Das TO-Gehäuse weist einen Sockel mit einem Montagebereich für ein optoelektronisches Bauelement auf, wobei das TO-Gehäuse einen Submount für das optoelektronische Bauelement umfasst, wobei der Sockel zumindest einen in einer Durchführung angeordneten Signalpin zum Anschluss des optoelektronischen Bauelements umfasst.

Um den Signalpin mit dem optoelektronischen Bauelement, insbesondere mit dem Submount, zu verbinden, ist gemäß einer Ausführungsform der Erfindung vorgesehen, dass der Signalpin stirnseitig eine Anschlussfläche für das optoelektronische Bauelement aufweist, welche insbesondere durch eine Stirnseite der Verdickung gebildet wird.

Gemäß der Erfindung dient also die Stirnfläche des Signalpins, insbesondere die Stirnfläche der Verdickung, als Anschlussfläche für den Submount.

Die Signalleiterbahnen des Submounts sind insbesondere koaxial mit den Signalpins ausgerichtet, wobei die Leiterbahn mit ihrem Ende senkrecht auf der Stirnfläche des Signalpins sitzt.

So ist zwischen der als Signalleiterbahn dienenden Leiterbahn des Submounts und Anschlussfläche des Signalpins eine Kante vorhanden, in welche eine Lotkehle zum Bereitstellen einer elektrischen Verbindung eingesetzt sein kann.

Gemäß der anderen Ausführungsform, welche sich nicht auf den stirnseitigen Anschluss bezieht, sondern bei welcher der Signalpin seitlich kontaktiert ist, kann der Signalpin aber auch eine sich über die Verdickung hinausgehende Verlängerung in das Gehäuseinnere umfassen. An dieser Verlängerung kann die Signalleiterbahn des Submounts seitlich angeschlossen werden. Die Verlängerung dient in diesem Falle als Lötfahne.

Dabei erstreckt sich ebenfalls zumindest eine Leiterbahn des Submounts koaxial zum Signalpin.

Gemäß vorstehend beschriebener erster Ausführungsform kann die sich koaxial erstreckende Leiterbahn an einer Stirnseite des Signalpins angeschlossen, insbesondere angelötet sein.

Gemäß einer bevorzugten Ausführungsform der Erfindung umfasst der Submount zwei Leiterbahnen, welche sich koaxial zu zwei Signalpins erstrecken.

Gemäß einem weiteren Aspekt betrifft die Erfindung ein TO-Gehäuse, insbesondere mit einem oder mehrerer vorstehend beschriebener Merkmale.

Das TO-Gehäuse weist einen Sockel mit einem Montagebereich für ein optoelektronisches Bauelement auf, wobei das TO-Gehäuse einen Submount für das optoelektronische Bauelement umfasst, wobei der Sockel zumindest einen in einer Durchführung angeordneten Signalpin zum Anschluss des optoelektronischen Bauelements umfasst.

Gemäß der Erfindung umfasst der Submount stirnseitig, insbesondere zumindest unterhalb einer zumindest einen sich koaxial zu einem Signalpin erstreckenden Leiterbahn, einen ausgedünnten Bereich, welcher mit einer Erdleiterbahn versehen ist. Der nicht ausgedünnte Bereich weist ebenfalls eine Erdleiterbahn auf. Diese ist mit der Erdleiterbahn des ausgedünnten Bereichs elektrisch verbunden.

Der Submount ist insbesondere als mehrlagige Leiterplatte ausgebildet, wobei eine Oberseite des Submounts die zumindest eine als Signalleiterbahn dienende Leiterbahn bereitstellt und eine Unterseite des Submounts eine Erdleiterbahn umfasst.

An der Stirnseite angrenzend zum Signalpin ist der Submount gemäß vorstehend definiertem Aspekt der Erfindung derart ausgebildet, dass dieser dünner ist, wodurch die Erdleiterbahn näher an die zumindest eine Signalleiterbahn heranrückt.

Es ist also eine Stufe in der Dicke des Submounts vorgesehen, der Submount ist in einem stirnseitigen Bereich abschnittsweise dünner ausgebildet.

Es ist insbesondere vorgesehen, dass sich die Dicke des Submounts in dem ausgedünnten Bereich um zumindest 20% gegenüber einem angrenzenden Bereich verringert.

Der ausgedünnte Bereich kann durch eine Ausnehmung des Submounts an seiner Kante, insbesondere einer Ausnehmung mit rechteckigem Querschnitt, bereitgestellt werden. Alternativ kann eine V-förmiger Ausnehmung z.B. durch ein Sägeblatt bereitgestellt werden.

Diese kann insbesondere bei einer quaderförmigen Ausgestaltung zwischen 0,1 und 0,3 mm breit und/oder hoch sein und/oder die gesamte Länge der Kante des Submounts einnehmen.

Es hat sich herausgestellt, dass so auf einfache Weise die Impedanz verringert werden konnte.

Gemäß einer weiteren Weiterbildung der Erfindung weist die Durchführung unterhalb eines Bodens des Sockels eine Stufe auf.

Durch die Stufe ist also der Durchmesser der Durchführung angrenzend zum Boden des Gehäuses gegenüber dem restlichen Bereich der Durchführung reduziert.

Es ist insbesondere vorgesehen, dass der Durchmesser der Durchführung oberhalb der Stufe mindestens 10% kleiner ist als unterhalb der Stufe.

Durch die Stufe und den damit einhergehenden Bereich der Durchführung mit verringertem Durchmesser kann die Kapazität des Signalpfades lokal erhöht werden.

Bei einer weiteren Ausführungsform der Erfindung kann die Durchführung auf zumindest einer Seite einen Deckel aus dielektrischem Material aufweisen.

Der Deckel kann insbesondere als Lochscheibe aus Glas, Keramik und/oder Glaskeramik ausgebildet sein. Durch einen derartigen Deckel kann das Hochziehen des Isoliermaterials entlang des Signalpins bei der Herstellung reduziert werden. Beim Verwenden eines Einschmelzglases für die Durchführung kann insbesondere eine Glasbenetzung des Signalpins oberhalb der Durchführung weitgehend vermieden werden.

Bei einer weiteren Ausführungsform der Erfindung wird als Isolationsmaterial ein erstes Isolationsmaterial verwendet, welches Glas und/oder Glaskeramik umfasst, wobei im Bereich des Bodens des Sockels angrenzend an das Isolationsmaterial ein weiteres Isolationsmaterial angeordnet ist, welches eine relative Permittivität εᵣ (bei 18 °C und 50 Hz) hat, die höher ist als die des ersten Isolationsmaterials.

Bei dieser Ausführungsform der Erfindung umfasst also die Durchführung zwei Bereiche, bei denen die Permittivität des Isolationsmaterials unterschiedlich ist.

Angrenzend an den Boden des Sockels hat das Isolationsmaterial eine höhere relative Permittivität als im restlichen Bereich der Durchführung.

So lässt sich lokal die Kapazität der Durchführung erhöhen.

Das weitere Isolationsmaterial mit der höheren relativen Permittivität ist vorzugsweise höher schmelzend ausgebildet als das erste Isolationsmaterial.

Es kann insbesondere vorstehend beschriebener Deckel das weitere Isolationsmaterial bereitstellen.

Durch die Erfindung kann eine Einrichtung zur Datenübertragung mit einer Datenübertragungsrate von zumindest 100 GBit/s pro Wellenlänge bereitgestellt werden, welche zumindest ein vorstehend beschriebenes TO-Gehäuse umfasst.

### Kurzbeschreibunq der Zeichnungen

Der Gegenstand der Erfindung soll im Folgenden bezugnehmend auf Ausführungsbeispiele anhand der Zeichnungen Fig. 1 bis Fig. 30 näher erläutert werden.
Fig. 1 bis 4 sind perspektivische Darstellungen eines Ausführungsbeispiels eines erfindungsgemäßen TO-Gehäuses (ohne Kappe).
Fig. 5 ist eine perspektivische Ansicht auf die Innenseite des Gehäuses ohne Submount.
Fig. 6 ist eine Detailansicht, welche teilweise aufgeschnitten ist und in welcher Details der Leiterplatte dargestellt sind.
Fig. 7 ist eine perspektivische Ansicht der Unterseite des Sockels.
Fig. 8 ist eine Detailansicht eines Schnitts durch eine Durchführung des Sockels.
Die Graphen gemäß Fig. 9 und Fig. 10 zeigen die Reflexionsdämpfung und Einfügedämpfung des in Fig. 1 bis Fig. 8 dargestellten Gehäuses im Vergleich mit einem aus dem Stand der Technik bekannten TO-Gehäuse.
Fig. 11 ist eine Schnittansicht einer Durchführung, die auf einer Seite randseitig einen vergrößerten Durchmesser aufweist.
Fig. 12 ist eine Schnittansicht einer Durchführung, bei welcher auf einer Seite der Signalpin eine Verdickung aufweist.
Fig. 13 ist eine Detaildarstellung des Signalpins.
Die Graphen gemäß Fig. 14 zeigen die Reflexionsdämpfung eines erfindungsgemäßen TO-Gehäuses bei Verwendung verschiedener Glassorten.
Die Graphen gemäß Fig. 15 zeigen die Reflexionsdämpfung eines erfindungsgemäßen TO-Gehäuses, bei welchem die Durchführung teils mit Glas, teils mit einem Kunststoff gefüllt ist bei Verwendung verschiedener Glas- und Kunststoffsorten.

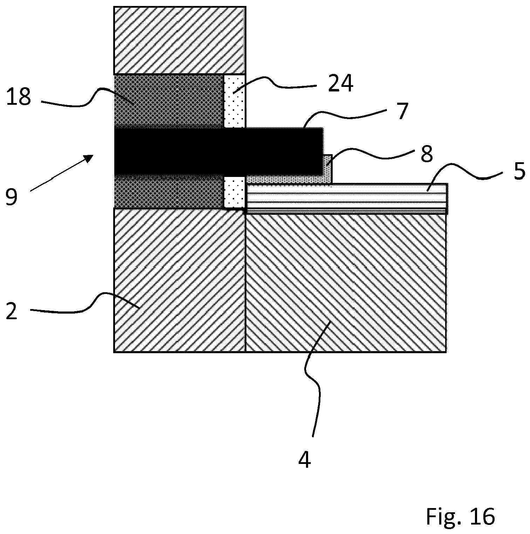

Fig. 16 ist eine Schnittansicht eines Ausführungsbeispiels eines Sockels im Bereich der Durchführung des Signalpins und des Submounts für das optoelektronische Bauelement.

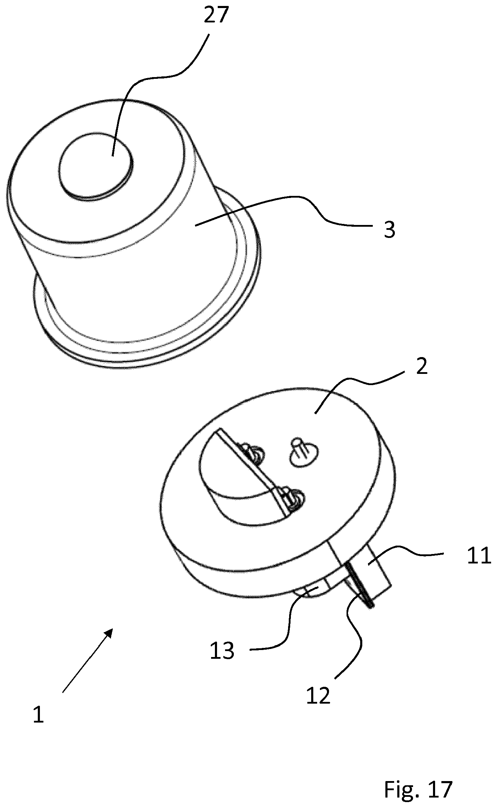

Fig. 17 ist eine perspektivische Ansicht eines TO-Gehäuse mit Kappe.

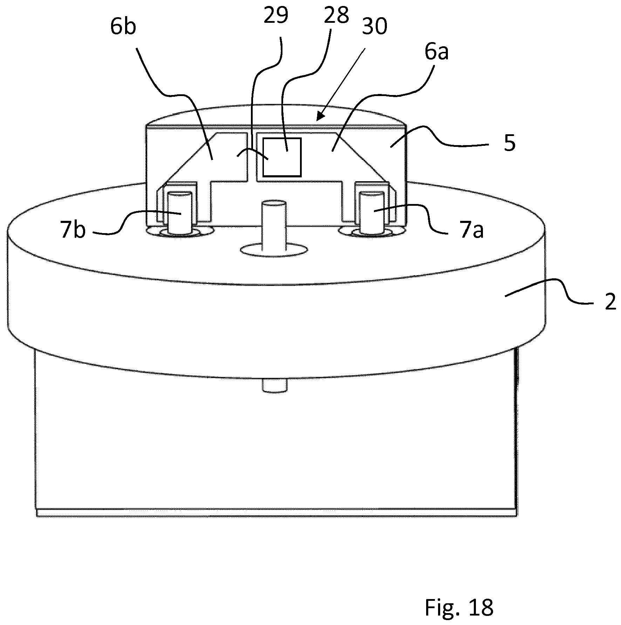

Fig. 18 zeigt das mit einem optoelektronischen Bauelement bestückte TO-Gehäuse.

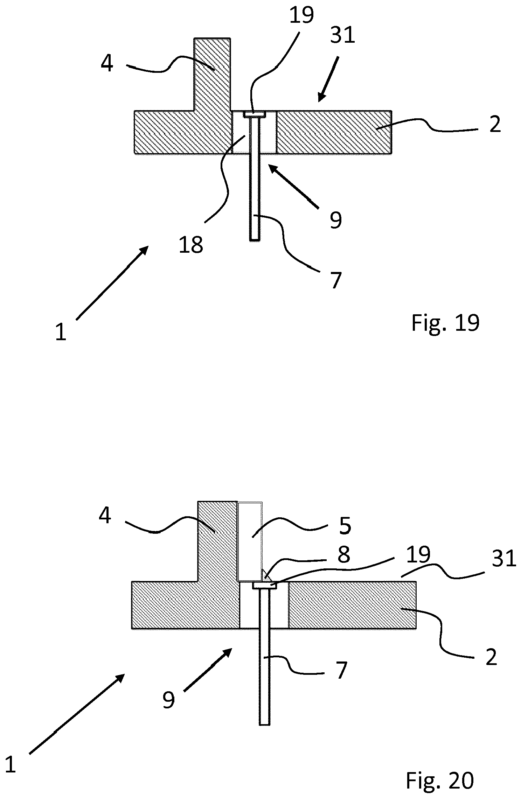

Fig. 19 ist eine schematische Schnittansicht einer weiteren Ausführungsform eines TO-Gehäuses, bei welchem der Signalpin eine Verdickung aufweist, welche auf einer Ebene mit dem Boden des Sockels liegt.
Fig. 20 zeigt das in Fig. 19 dargestellte Gehäuse mit montiertem Submount.

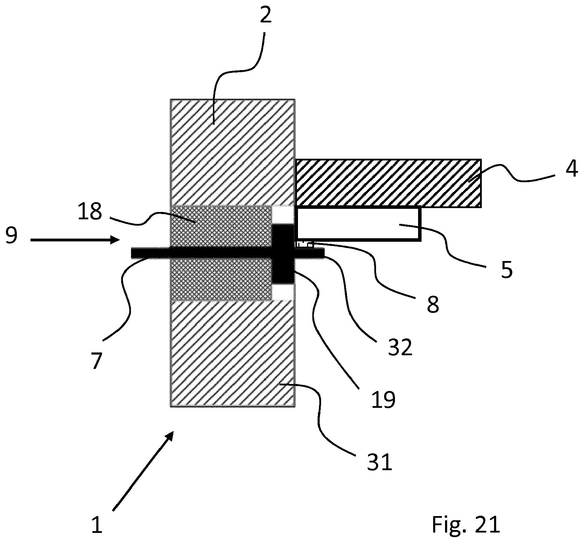

Fig. 21 ist eine weitere schematische Ansicht eines TO-Gehäuses mit einem Signalpin, der eine Verdickung aufweist, die auf einer Ebene mit dem Boden liegt.

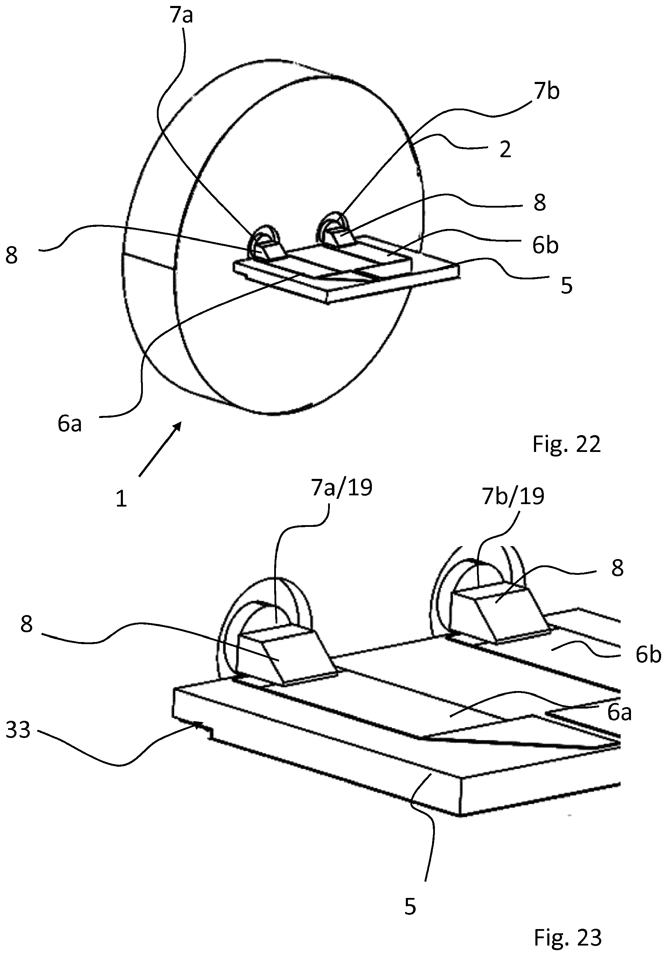

Fig. 22 ist eine perspektivische Ansicht eines TO-Gehäuses, welches mit einem Submount bestückt ist, wobei die Signalpins eine Verdickung aufweisen.
Fig. 23 ist eine Detailansicht der Fig. 22 und zeigt den Bereich der Stirnseite des Submounts.

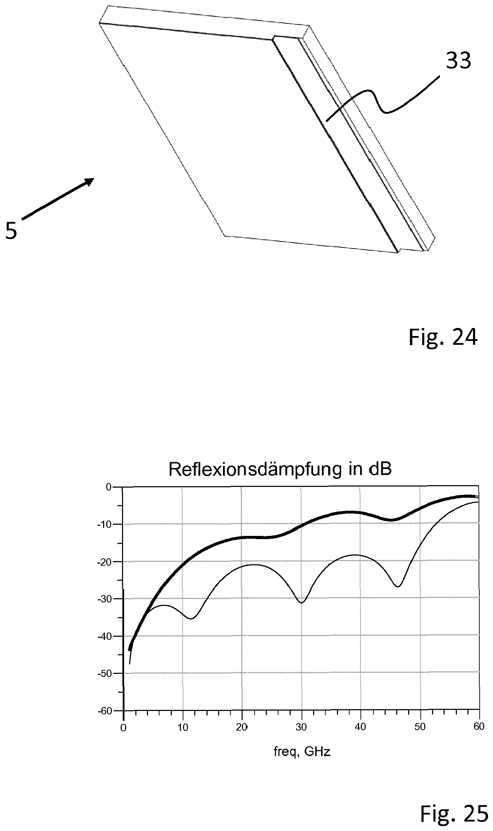

Fig. 24 ist eine perspektivische Ansicht nur des Submounts.
Fig. 25 zeigt anhand von zwei Graphen die Reflexionsdämpfung des in Fig. 22 und Fig. 23 dargestellten TO-Gehäuses 1 in Vergleich mit einem TO-Gehäuse 1, welches keine Signalpins 7 mit einer Verdickung 19 sowie einen Submount 5 mit einem ausgedünnten Bereich aufweist. Dass der ausgedünnte Bereich mit der Erdleiterbahn 16a bis 16d versehen ist, ist von großer Bedeutung und macht den Unterschied zu herkömmlichen Lösungen.

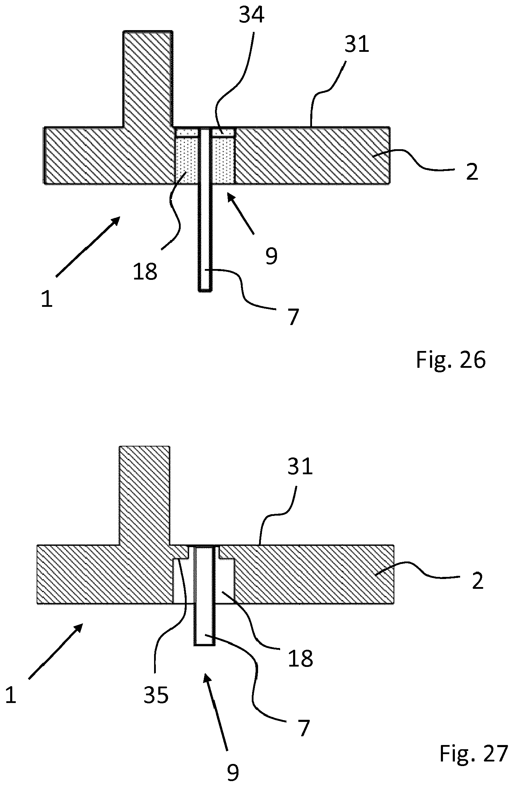

Fig. 26 ist eine schematische Schnittansicht eines TO-Gehäuses, bei welchem die Durchführung einen Deckel mit höherer Permittivität aufweist.
Fig. 27 ist eine schematische Schnittansicht eines TO-Gehäuses, bei welchem die Durchführung eine Stufe aufweist.

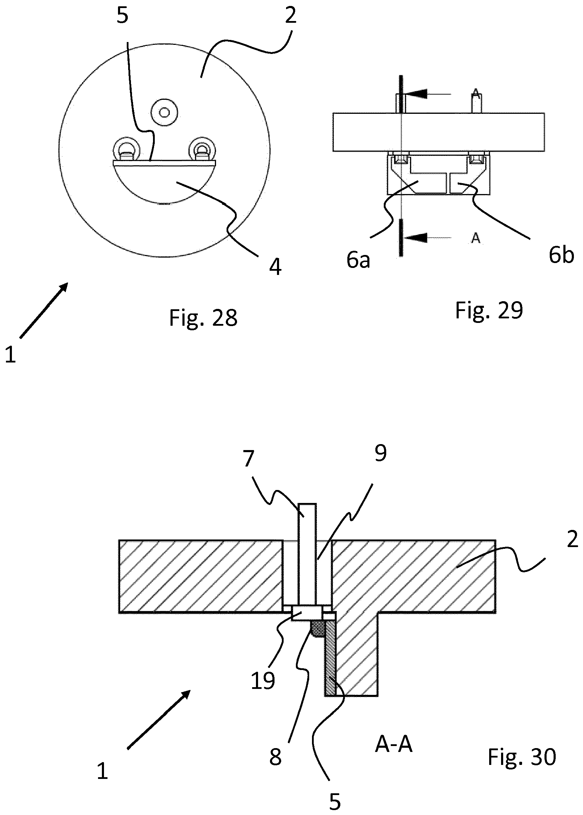

Fig. 28 bis Fig. 30 zeigen eine Ausführungsform eines TO-Gehäuses, bei welcher der Signalpin eine Verdickung aufweist, welche nur teilweise in der Durchführung angeordnet ist.

### Detaillierte Beschreibung der Zeichnungen

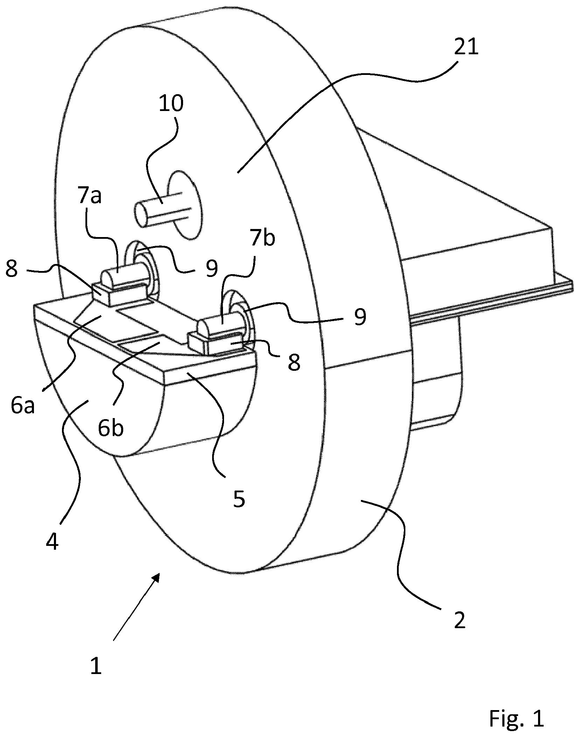

Fig. 1 ist eine perspektivische Ansicht eines erfindungsgemäßen TO-Gehäuses 1.

Das TO-Gehäuse 1 umfasst einen Sockel 2. Der Sockel 2 hat in diesem Ausführungsbespiel einen kreisförmigen Querschnitt. Vorzugsweise besteht der Sockel 2 aus Metall, insbesondere aus einem Metall, welches mit einer Beschichtung, beispielsweise aus Gold, versehen ist.

Der Sockel 2 umfasst in diesem Ausführungsbeispiel die beiden Signalpins 7a, 7b, welche über die Durchführungen 9 durch den Sockel 2 geführt sind.

Der Sockel 2 umfasst eine Oberseite 21, welche nach Anbringen einer Kappe eine Innenwand des dann hermetisch verschlossenen TO-Gehäuses 1 bildet.

Die Signalpins 7a, 7b sind mittels eines Lots 8 mit den Leiterbahnen 6a, 6b verbunden.

Über die Leiterbahnen 6a, 6b wird ein optoelektronisches Bauelement, insbesondere eine Laserdiode (nicht dargestellt) kontaktiert. Dieses Ausführungsbeispiel der Erfindung ist also für eine Laserdiode mit zwei Signalleiterpfaden vorgesehen.

Die Leiterbahnen 6a, 6b befinden sich auf einem Submount 5, welcher seinerseits auf ein Podest 4 aufgebracht ist, welches aus der Oberseite 21 des Sockels 2 hervorragt.

Vorzugsweise ist das Podest 4 einstückig mit dem Sockel ausgebildet. Sockel 2 und Podest 4 können insbesondere als einstückiges Stanzteil ausgebildet sein.

In diesem Ausführungsbeispiel hat das Podest 4 einen kreissegmentförmigen Querschnitt. Es ist aber ebenso denkbar, das Podest 4 anders auszugestalten, beispielsweise mit einem rechteckigen Querschnitt.

Der Submount 5 ist koaxial mit den Signalpins 7a, 7b ausgerichtet, so dass die Unterseite der Laserdiode im bestückten Zustand senkrecht zur Oberseite 21 des Sockels 2 ausgerichtet ist.

Der Submount 5 besteht vorzugsweise aus einer Keramik. Beispielsweise kann eine Aluminiumoxidkeramik verwendet werden. Vorzugsweise besteht der Submount 5 aus einer Aluminiumnitritkeramik. Diese hat eine hohe Wärmeleitfähigkeit.

Neben den Signalpins 7a, 7b umfasst das TO-Gehäuse 1 in diesem Ausführungsbeispiel zumindest einen weiteren Pin 10. Dieser kann beispielsweise dem Anschluss einer Monitordiode dienen. Es versteht sich, dass andere Ausführungsbeispiele der Erfindung auch noch weitere Pins, beispielsweise zur Ansteuerung eines thermoelektrischen Kühlers (nicht dargestellt), umfassen können.

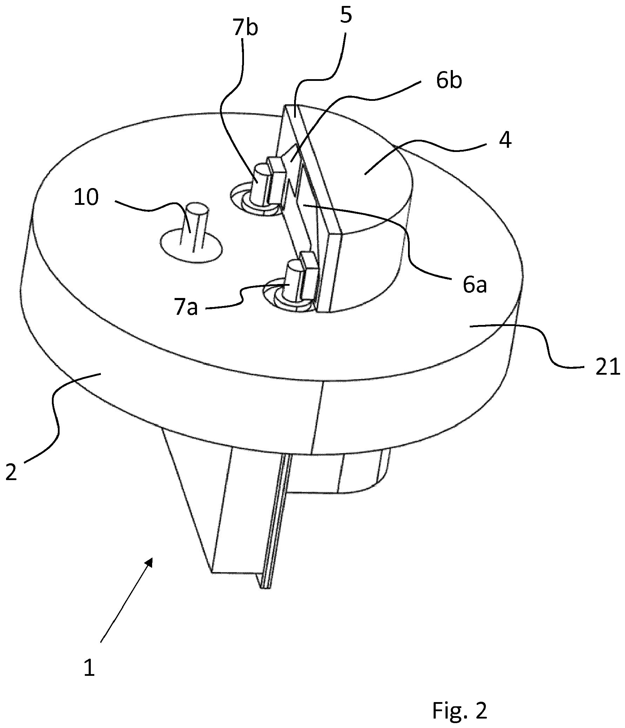

Fig. 2 ist eine weitere perspektivische Ansicht des TO-Gehäuses 1.

Zu erkennen ist insbesondere, dass die Signalpins 7a, 7b sowie der Pin 10 senkrecht aus der Oberseite des Sockels 2 herausragen.

Gleiches gilt für den Podest 4 mit dem Submount 5.

Die Signalpins 7a, 7b gehen koaxial in die Leiterbahnen 6a, 6b über. Die Leiterbahnen 6a und 6b auf dem Submount 5 laufen aufeinander zu, so dass ein optoelektronisches Bauelement unmittelbar auf eine Leiterbahn 6a aufgesetzt werden kann und mittels eines Bonddrahts mit der anderen Leiterbahn 6b kontaktiert werden kann.

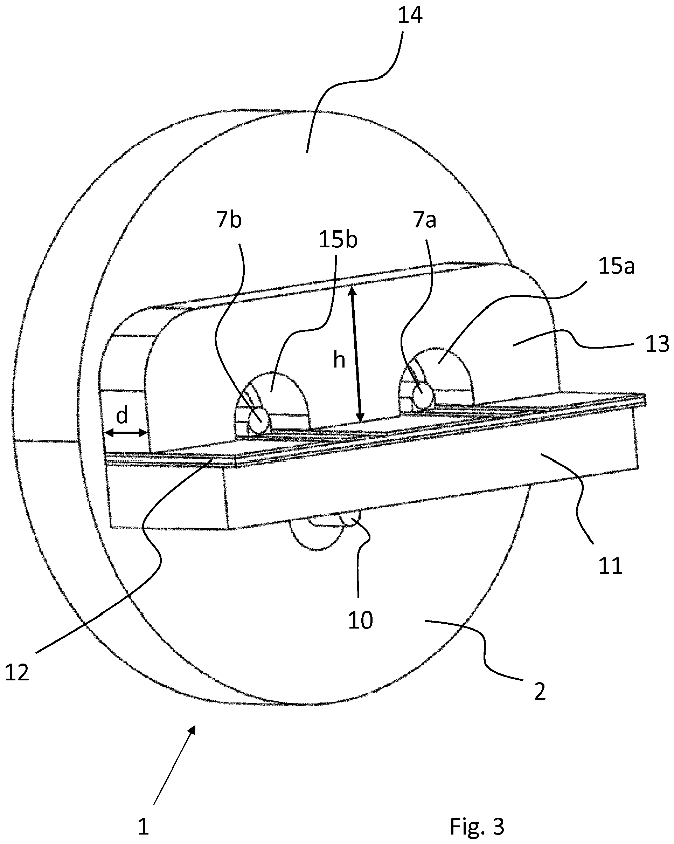

Fig. 3 ist eine weitere perspektivische Ansicht des TO-Gehäuses 1, in welcher die Unterseite 14 des TO-Gehäuses dargestellt ist.

Zu erkennen sind die aus der Unterseite 14 herausragenden Signalpins 7a, 7b.

Die Signalpins 7a, 7b sind mit einer Leiterplatte 12 verbunden.

Die Leiterplatte 12 ist in dieser Ansicht nur teilweise dargestellt. Die Leiterplatte 12 kann beispielsweise als flexible Leiterplatte ausgestaltet sein und abgewinkelt mit einem elektronischen Modul verbunden sein (nicht dargestellt).

Die Leiterplatte 12 ist auf ihrer Unterseite mit einer Versteifung 11 versehen. Die Versteifung 11 besteht vorzugsweise aus dielektrischem Material, beispielsweise aus einem Kunststoff oder aus einer Keramik.

Durch die Versteifung 11 wird erreicht, dass beispielsweise auch eine flexible Leiterplatte 12 angrenzend an die Unterseite 14 des Sockels 2 steif und stabil ausgebildet ist.

Um eine stabile mechanische Verbindung sowie um eine Erdverbindung zwischen Sockel 2 und Leiterplatte 12 bereitzustellen, ist ein Metallblock 13 vorgesehen, welcher zum einen mit der Leiterplatte 12 und zum anderen mit der Unterseite 14 des Sockels 2 verbunden, insbesondere verlötet, ist.

Der Metallblock 13 bildet einen Winkel, der eine koaxiale Anordnung der Leiterplatte 12 zu den Signalpins 7a, 7b ermöglicht.

In diesem Ausführungsbeispiel ist der Metallblock 13 als Brücke ausgebildet, die die Signalpins 7a, 7b jeweils in einem Bogen 15a, 15b überspannt.

Die Signalpins 7a, 7b ragen vorzugsweise nicht über den Metallblock 13 hinaus.

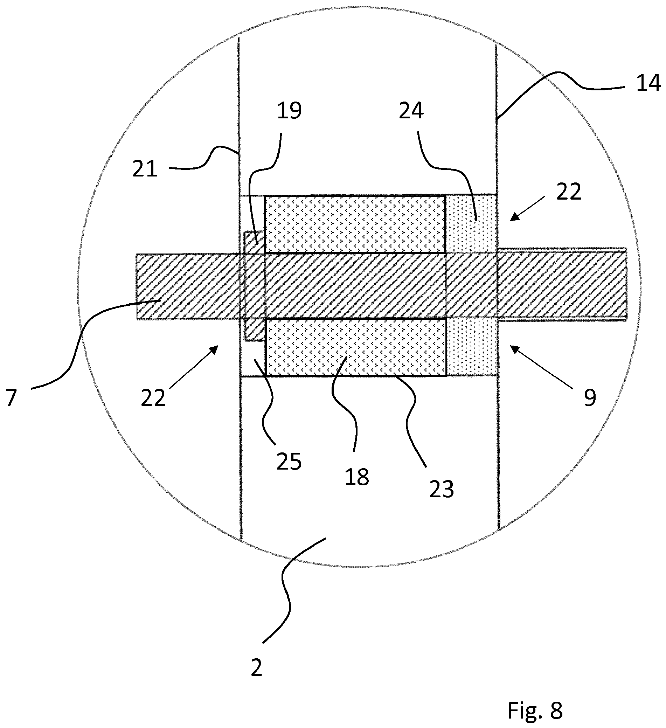

Der Metallblock 13 kann im Bereich der Bögen 15a, 15b bis in den Bereich der Durchführung (9 in Fig. 1 und Fig. 8) hineinragen.

Durch den Metallblock 13 sind die Signalpins 7a, 7b auch außerhalb der Durchführung geschirmt.

Der Metallblock 13 ist vorzugsweise plattenförmig ausgebildet.

Durch den Metallblock 13 wird eine Erdverbindung sowohl zwischen den Signalpins 7a, 7b als auch neben den Signalpins 7a, 7b ermöglicht.

Vorzugsweise hat der Metallblock 13 eine Dicke d von über 0,1 mm, besonders bevorzugt über 0,5 mm und/oder von unter 5 mm, besonders bevorzugt von unter 2 mm.

Der Metallblock 13 kann sich in der Breite über einen großen Teil des Durchmessers des Sockels 2 erstrecken, insbesondere über zumindest 20 %, vorzugsweise über zumindest 50 % des Durchmessers des Sockels 2.

Die Höhe h des Metallblocks 13 entspricht vorzugsweise mindestens dem 1,5fachen Durchmesser der Durchführung.

Neben einer stabilen mechanischen Verbindung der Leiterplatte 12 hat der Metallblock 13 gleichzeitig den Vorteil, dass das Anbringen der Signalpins 7a, 7b an die Leiterplatte 12 vom Bereitstellen der Erdverbindung entkoppelt ist.

So können beispielsweise zunächst die Signalpins 7a, 7b mit der Leiterplatte 12 verlötet werden.

Da zu diesem Zeitpunkt ansonsten noch keine mechanische Verbindung zur Leiterplatte 12 vorhanden ist, können so Form- und Lagetoleranzen gut ausgeglichen werden.

Im nächsten Schritt kann der Metallblock 13 mit dem Sockel 2 und/oder der Leiterplatte 12 verbunden werden, um eine Erdverbindung herzustellen.

Weiter ist zu erkennen, dass auf der den Signalpins 7a, 7b gegenüberliegenden Seite der Leiterplatte 12 ein weiterer Pin 10 vorhanden ist. Der weitere Pin 10 sitzt ebenfalls in einer Durchführung und dient in diesem Ausführungsbeispiel dem Anschluss einer Monitordiode.

Der weitere Pin 10 ist an der gleichzeitig als Leiterplatte dienenden Versteifung 11 angeschlossen.

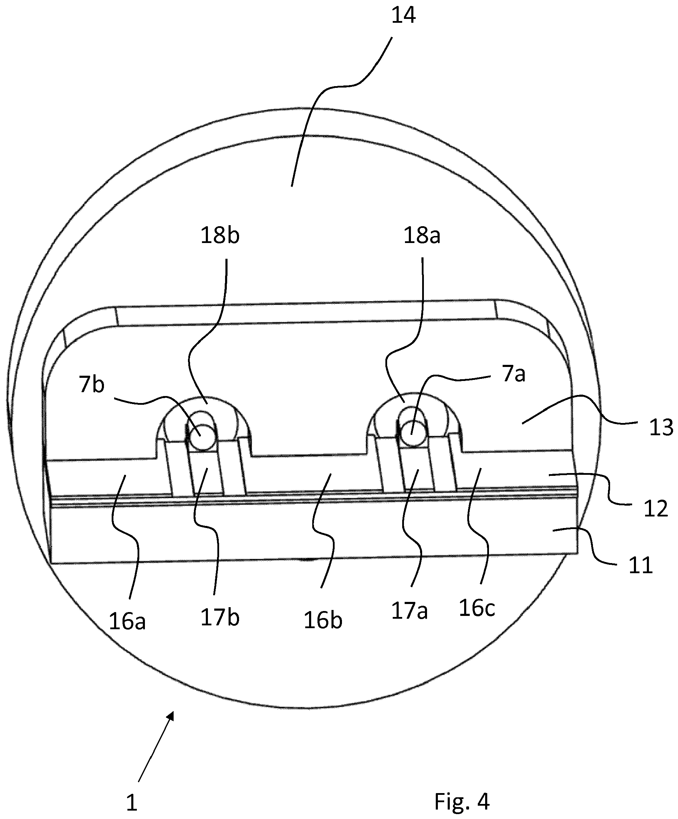

Fig. 4 ist eine weitere perspektivische Ansicht der Unterseite 14 des TO-Gehäuses.

Zu erkennen ist, dass die Signalpins 7a, 7b in einem Isolationsmaterial aus Glas 18a, 18b eingebettet sind.

Durch die so gebildeten Durchführungen ragen die Signalpins 7a, 7b aus der Unterseite 14 heraus.

Die Signalpins 7a, 7b sind koaxial mit Signalleiterbahnen 17a, 17b der Leiterplatte 12 verbunden.

Zwischen den Signalleiterbahnen 17a, 17b befindet sich auf der Leiterplatte 12 die Erdleiterbahn 16b. Die Erdleiterbahnen 16a und 16c grenzen beidseitig an die Signalleiterbahnen 17a, 17b an. So sind die Signalleiterbahnen 17a, 17b von beiden Seiten geschirmt.

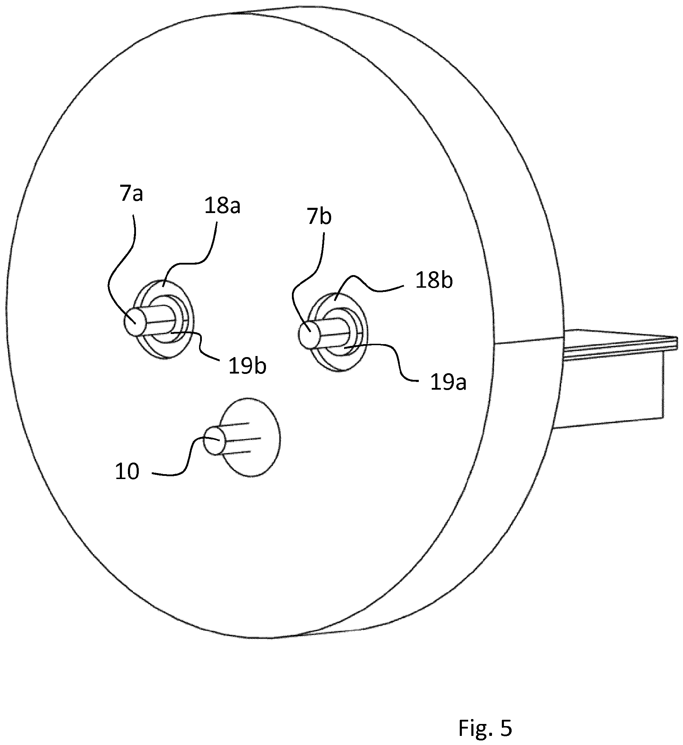

Fig. 5 ist eine Darstellung der Innenseite des TO-Gehäuses, wobei der Podest und der Submount ausgeblendet sind.

In dieser Ansicht ist zu erkennen, dass innenseitig die in dem Isolationsmaterial aus Glas 18a, 18b eingebetteten Signalpins 7a, 7b jeweils eine Verdickung 19a, 19b aufweisen. Im Bereich dieser kragenförmigen Verdickungen 19a, 19b ist ein Bereich ohne Isolationsmaterial aus Glas ausgebildet. Der hierdurch bedingte Impedanzsprung wird durch die Verdickungen 19a, 19b zumindest teilweise kompensiert.

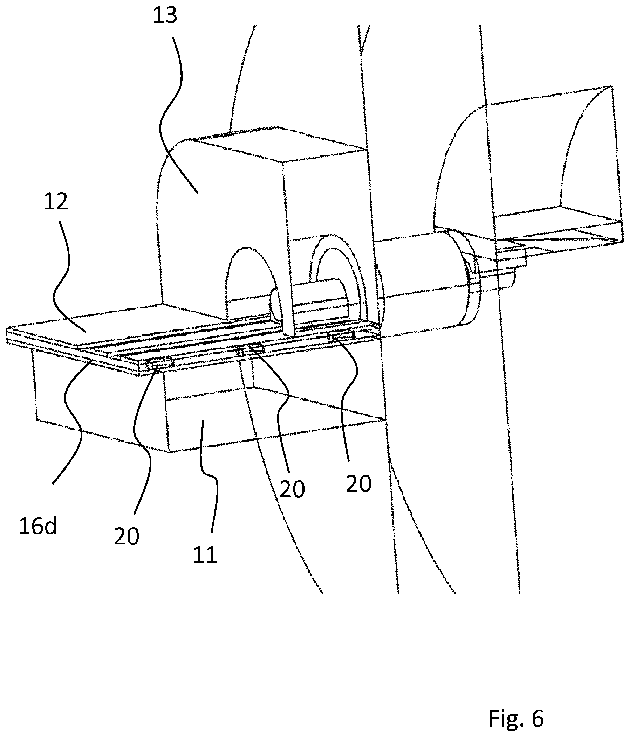

Fig. 6 ist eine aufgeschnittene perspektivische Ansicht, in welcher zu erkennen ist, dass die Leiterplatte 12 als mehrlagige Leiterplatte ausgebildet ist.

Auf der Oberseite umfasst die Leiterplatte 12 die in Fig. 4 dargestellten Signalleiterbahnen 17a, 17b sowie die Erdleiterbahnen 16a bis 16c.

Die Erdleiterbahnen 16a bis 16c sind über Durchkontaktierungen 20 mit einer darunterliegenden Erdleiterbahn 16d verbunden, welche sich auch unterhalb der in Fig. 4 dargestellten Signalleiterbahnen 17a, 17b erstreckt und diese so schirmt.

Die so ausgestaltete Multilagenleiterplatte sitzt auf der Versteifung 11 und die Erdleiterbahnen 16a bis 16c sind mit dem Metallblock 13 verlötet.

Die Versteifung 11 ist also gleichzeitig als verdickter Bereich ausgebildet, welcher eine mehrlagige Leiterplatte bildet, durch welche eine Durchkontaktierung von der Unterseite bis zur Leiterplatte 12 bereitgestellt wird.

Die durch den verdickten Bereich bzw. die Versteifung 11 gebildete mehrlagige Leiterplatte ist als starre Leiterplatte ausgebildet, wohingegen die Leiterplatte 12 als vorzugsweise einlagige flexible Leiterplatte ausgebildet ist.

An der Unterseite der Versteifung 11 kann so der weitere Pin (10 in Fig. 3) zum Anschluss beispielsweise einer Monitor-Diode angeschlossen sein.

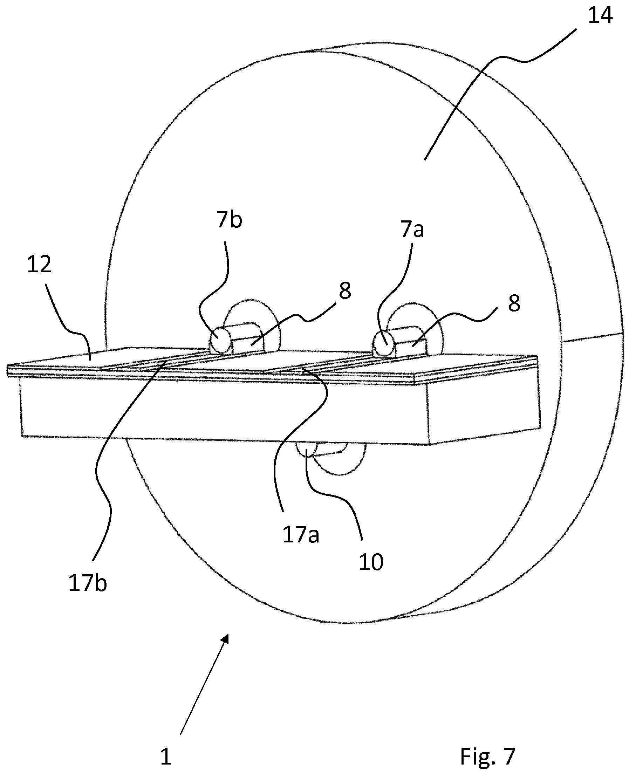

Fig. 7 ist eine weitere perspektivische Ansicht der Unterseite des TO-Gehäuses.

In dieser Ansicht ist der Metallblock ausgeblendet. Gut zu erkennen ist, dass die aus der Unterseite 14 herausragenden Signalpins 7a, 7b mittels eines Lots 8 mit den Signalleiterbahnen 17a, 17b der Leiterplatte 12 verbunden sind.

Fig. 8 ist eine Detailansicht eines Schnitts im Bereich einer Durchführung 9.

Ein Signalpin 7 ist in einem Isolationsmaterial 18 aus Glas in der Durchführung 9 angeordnet.

Hierzu umfasst der Sockel 2 ein Durchgangsloch 23.

Die Durchführung 9 bzw. das Durchgangsloch 23 ist aber nur teilweise mit dem Isolationsmaterial 18 aus Glas und/oder Glaskeramik ausgefüllt, so dass sowohl angrenzend an die Unterseite 14 als auch angrenzend an die Oberseite 21 ein von dem Isolationsmaterial 18 freier Bereich 22 vorhanden ist, welcher den Signalpin 7 umgibt und welcher nicht mit dem Isolationsmaterial 18 aus Glas und/oder Glaskeramik aufgefüllt ist.

Innenseitig ist in diesem nicht aufgefüllten Bereich 22 ein Hohlraum 25 vorhanden. Im Bereich des Hohlraums 25 ist eine Verdickung 19 des Signalpins 7 vorhanden.

Durch die Verdickung 19 des Signalpins 7 wird der Impedanzsprung aufgrund der geänderten Permittivität reduziert.

Auf der Außenseite ist der nicht aufgefüllte Bereich 22 mit einer Vergussmasse 24 aus Kunststoff ausgefüllt.

Vorzugsweise ist die Permittivität der Vergussmasse 24 aus Kunststoff der Permittivität des verwendeten Isolationsmaterials 18 aus Glas angepasst.

Insbesondere hat der Kunststoff eine Permittivität εᵣ von 4,0 +/- 2,5, besonders bevorzugt +/- 1,5.

Als Isolationsmaterial 18 aus Glas bzw. Glaskeramik wird vorzugsweise ein Glas und/oder Glaskeramik mit einer Permittivität Er (bei 18°C und 50 Hz) von unter 6,0, vorzugsweise von unter 5,0, verwendet.

Es kann insbesondere ein poröses Glas verwendet werden, insbesondere ein Glas mit einer geschlossenen Porosität von über 30%, und/oder eine Glaskeramik mit diesen Eigenschaften.

Der Durchmesser des Signalpins 7 beträgt außerhalb des Bereiches der Verdickung 19 vorzugsweise 0,1 bis 0,5 mm, besonders bevorzugt 0,2 bis 0,3 mm.

Die Durchführung 9 ist vorzugsweise zu 50 bis 90%, besonders bevorzugt zu 60 bis 80%, ihres Volumens mit dem Isolationsmaterial 18 aus Glas und/oder Glaskeramik gefüllt.

Die Verdickung 19 hat vorzugsweise mindestens den 1,2-fachen Durchmesser des angrenzenden Signalpins 7, insbesondere den 1,5- bis 2,5-fachen Durchmesser.

Die Verdickung 19 ist in dieser Ausführungsform 0,02 bis 0,2 mm, vorzugsweise 0,05 bis 0,1 mm, lang.

Die Länge der Durchführung 9 kann insbesondere 0,5 bis 2 mm, vorzugsweise 0,8 bis 1,5 mm, betragen.

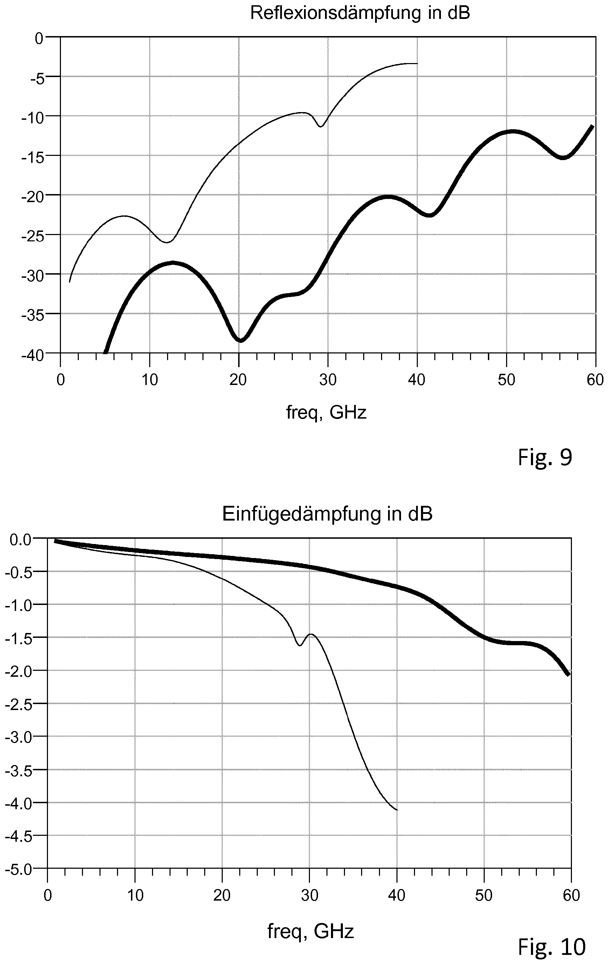

In Fig. 9 ist die Reflexionsdämpfung eines aus dem Stand der Technik bekannten TO-Gehäuses (dünne Kurve) mit der Reflexionsdämpfung eines erfindungsgemäßen TO-Gehäuses (dicke Kurve) verglichen. Zu erkennen ist insbesondere, dass eine Reflexionsdämpfung von etwa -10 dB von einer Frequenz von etwa 30 GHz auf etwa 50 GHz verschoben wurde. Die Reflexionsdämpfung ist also signifikant verbessert.

Gleiches gilt für die Einfügedämpfung, welche in Fig. 10 gegenübergetragen ist. Eine Einfügedämpfung von 2 dB wird bei knapp 60 GHz statt bei etwas über 30 GHz erreicht.

So kann durch die Erfindung eine etwa 25 GHz höhere Bandbreite bereitgestellt werden.

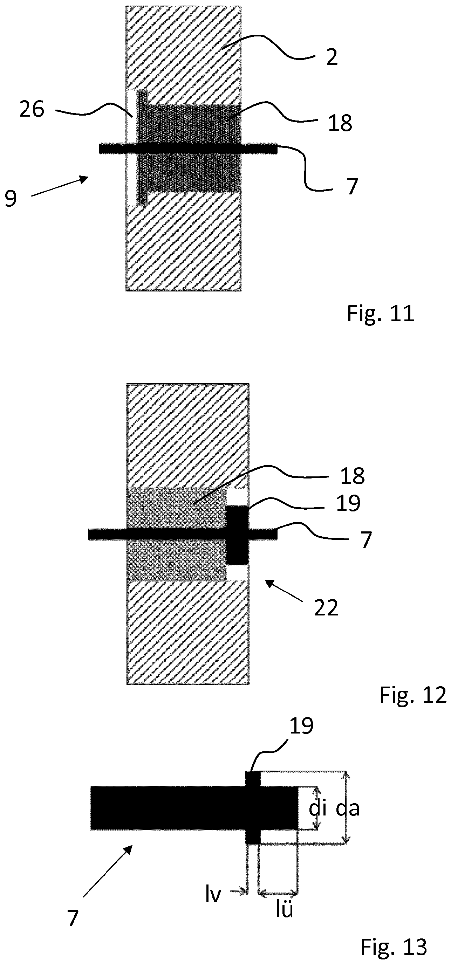

Bezugnehmend auf Fig. 11 bis Fig. 13 sollen weitere Maßnahmen zur Anpassung des Impedanzverlaufs der Durchführung 9 näher erläutert werden.

Fig. 11 ist eine schematische Schnittansicht eines weiteren Ausführungsbeispiels einer Durchführung 9, welche in den Sockel 12 eingebracht ist.

In diesem Ausführungsbeispiel ist ebenfalls ein Signalpin 7 in einem Isolationsmaterial 18 aus Glas und/oder Glaskeramik eingebettet. Auf zumindest einer Seite umfasst die Durchführung 9 einen Bereich 26 mit vergrößertem Durchmesser.

Der Bereich 26 mit vergrößertem Durchmesser ist teilweise mit dem Isolationsmaterial 18 aus Glas und/oder Glaskeramik aufgefüllt.

Durch den Bereich 26 mit vergrößertem Durchmesser wird ein Reservoir bereitgestellt, in dem Volumenschwankungen des Isolationsmaterials 18 aus Glas aufgenommen werden können.

Durch den vergrößerten Durchmesser des Bereichs 26 ändert sich dabei aber die Füllhöhe nur wenig.

Das in dem Bereich 26 vorhandene Isolationsmaterial 18 bildet eine Scheibe, entlang der sich die Impedanz sprunghaft ändert, was wiederum den Impedanzsprung aufgrund des darüber vorhandenen Hohlraums reduziert.

Der Bereich mit vergrößertem Durchmesser hat vorzugsweise mindestens den 1,2-fachen Durchmesser der angrenzenden Durchführung 9 sowie eine Länge von 0,05 bis 0,5 mm, vorzugsweise von 0,1 bis 0,3 mm.

Fig. 12 zeigt, wie eine Impedanzanpassung auch vorgenommen werden kann, indem in dem mit Isolationsmaterial 18 nicht aufgefüllten Bereich 22 der Signalpin 7 eine Verdickung 19 aufweist.

Fig. 13 ist eine Detaildarstellung des Signalpins 7.

Der Signalpin 7 weist im nicht verdickten Bereich einen Durchmesser dᵢ auf, welcher vorzugsweise zwischen 0,1 und 0,5 mm, besonders bevorzugt zwischen 0,2 und 0,3 mm liegt.

Die Verdickung 19 ist in diesem Ausführungsbeispiel stufig, also als kreiszylindrischer Abschnitt ausgebildet.

Die Verdickung 19 kann aber auch eine andere Form haben, insbesondere vorne und/oder hinten eine Fase aufweisen. So geht die Verdickung 19 nicht sprunghaft, sondern graduell in den größten Durchmesser dₐ über. Dies bedingt einen sich graduell ändernden Impedanzverlauf.

Die Verdickung 19 hat einen Durchmesser dₐ, welcher bevorzugt mindestens dem 1,2-fachen Durchmesser dᵢ entspricht, besonders bevorzugt das 1,5- bis 2,5-fache des Durchmessers dᵢ beträgt.

Die Verdickung 19 hat vorzugsweise eine Länge lᵥ von 0,02 bis 0,2 mm, besonders bevorzugt von 0,05 bis 0,1 mm.

Die Länge des sich daran anschließenden Überstandes l_{ü} beträgt vorzugsweise 0,2 bis 0,5 mm.

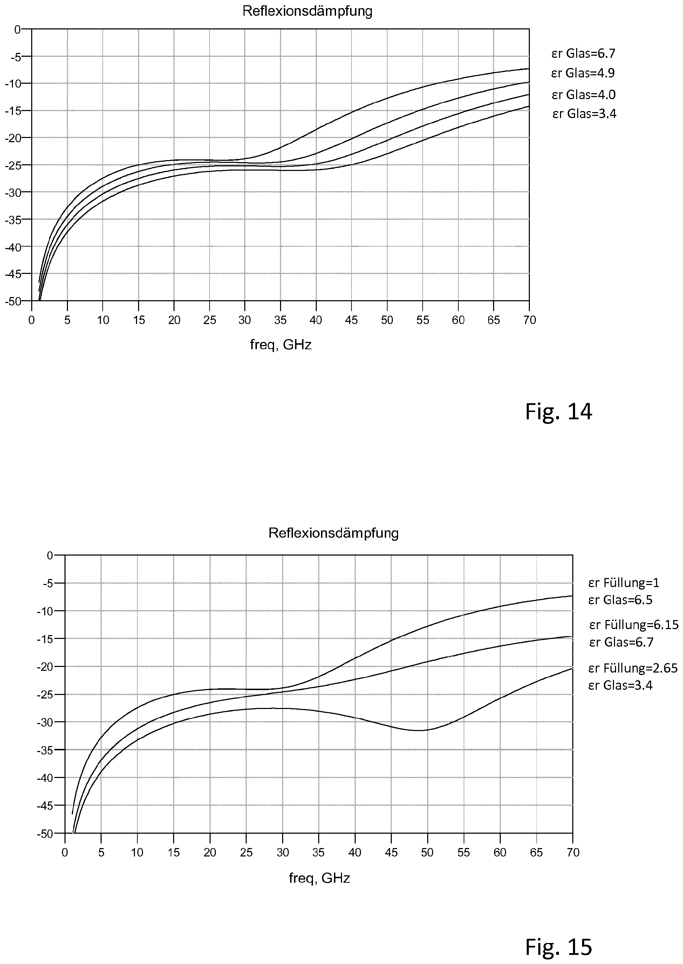

Der Graph gemäß Fig. 14 zeigt die Reflexionsdämpfung eines Ausführungsbeispiels der Erfindung, bei welchem eine Durchführung mit jeweils einem Isolationsmaterial aus Glas mit einer unterschiedlichen Permittivität aufgefüllt wurde.

Zu erkennen ist, dass sich die Reflexionsdämpfung verbessert, je geringer die Permittivität des Isolationsmaterials aus Glas ist.

Fig. 15 zeigt die Reflexionsdämpfung eines erfindungsgemäßen TO-Gehäuses bei Verwendung verschiedener Gläser als Isolationsmaterial sowie verschiedener Füllungen für den von Glas ausgesparten Bereich der Durchführung.

Zu erkennen ist, dass die Reflexionsdämpfung ohne Füllung (εᵣ Füllung = 1 und εᵣ Glas = 6,5) am schlechtesten ist.

Eine optimale Reflexionsdämpfung kann durch Verwendung eines Glases mit niedriger Permittivität und gleichzeitig Verwendung einer Füllung erreicht werden, deren Permittivität an die Permittivität des Glases angepasst ist.

Bezugnehmend auf Fig. 16 soll anhand einer schematischen Schnittansicht erläutert werden, wie ein Signalpin 7 zur Impedanzanpassung und/oder zur Verwendung eines dünneren Submounts 5 exzentrisch in die Durchführung 9 eingebracht werden kann.

In diesem Ausführungsbeispiel ist ein in ein Isolationsmaterial 18 aus Glas oder Glaskeramik eingebetteter Signalpin 7 vorgesehen, welcher mittels eines Lots 8 mit dem auf dem Podest 4 sitzenden Submount 5 verbunden ist.

Die Durchführung 9 ist nur teilweise mit dem Isolationsmaterial 18 aus Glas aufgefüllt.

Angrenzend zum Isolationsmaterial aus Glas 18 ist ein ausgesparter Bereich mit einer Vergussmasse 24 aus Kunststoff befüllt.

Zu erkennen ist, dass der Signalpin 7 exzentrisch in der Durchführung 9 sitzt und so in Richtung des Submounts 5 verschoben ist.

Der Submount 5 hat vorzugsweise eine Dicke von 0,05 bis 2 mm, besonders bevorzugt von 0,1 bis 0,2 mm. Der Submount besteht vorzugsweise aus einer Keramik, insbesondere aus Aluminiumoxid oder Aluminiumnitrit.

Gegenüber der Mittelachse der Durchführung 9 ist die Mittelachse des Signalpins vorzugsweise um 0,01 bis 0,15 mm, besonders bevorzugt 0,02 bis 0,08 mm, verschoben.

Der Submount 5 ragt bis in den Bereich der Durchführung 9 hinein, ist aber vom Signalpin 7 beabstandet, um das Einfließen von Lot 8 zu ermöglichen.

Der Abstand des Signalpins 7 vom Submount 5 beträgt vorzugsweise zwischen 0,05 und 0,3 mm, besonders bevorzugt zwischen 0,1 und 0,2 mm.

Fig. 17 zeigt in einer perspektivischen Ansicht ein Set zur Ausbildung eines TO-Gehäuses 1. Beim Ausführungsbeispiel der Fig. 19 und 20 ist das Einglasloch teilweise mit Glas befüllt (nicht dargestellt).

Das TO-Gehäuse 1 besteht aus dem Sockel 2 sowie der Kappe 3, welche mit einem Fenster 27 versehen ist. Das Fenster 27 ist insbesondere als Linse ausgebildet.

Der Sockel 2 kann mit mindestens einem optoelektronischen Modul, beispielsweise einer Laserdiode oder einer Monitordiode, bestückt werden. Danach wird die Kappe 3 auf den Sockel aufgebrauch, z.B. verlötet oder verschweißt.

Der Metallblock 13 sowie die mit der Versteifung 11 versehene Leiterplatte 12 können auch nach dem Auflöten der Kappe 3 angebracht werden.

Wie eingangs beschrieben, ist dabei von Vorteil, dass das Verbinden der Signalpins 7 vom Bereitstellen einer Erdverbindung entkoppelt ist.

Fig. 18 zeigt in einer schematischen Ansicht, wie nunmehr das TO-Gehäuse 1 mit einer Laserdiode 28 bestückt ist.

Auf dem Submount 5 ist ein Montagebereich 30 ausgebildet.

In diesem Ausführungsbeispiel ist die Laserdiode 28 auf die auf dem Submount 5 vorhandene Leiterbahn 6a aufgesetzt und so mit dem Signalpin 7a verbunden.

Um mit dem Signalpin 7b kontaktiert zu werden, ist ein Bonddraht 29 vorhanden, welcher die Laderdiode 28 mit der Leiterbahn 6b verbindet.

Da die Leiterbahnen 6a und 6b sich unmittelbar gegenüberliegen, kann die Länge des Bonddrahts 29 kurz gehalten werden, insbesondere unter 0,5 mm liegen.

Fig. 19 ist eine Schnittansicht eines TO-Gehäuses 1 gemäß einem weiteren Aspekt der Erfindung.

Bei dieser Ausführungsform umfasst der Sockel 2, wie in den vorstehend beschriebenen Ausführungsvarianten, einen Podest 4, welcher der Montage des Submounts dient.

Das TO-Gehäuse 1 kann auf Seite der hier nicht dargestellten Leiterplatte einen Metallblock umfassen (11 in Fig. 3). Die Erfindung bezieht sich aber auch auf ein TO-Gehäuse 1, welches den vorstehend beschriebenen Metallblock 11 nicht umfasst.

Gemäß der in Fig. 19 dargestellten Ausführungsform ist der im Isolationsmaterial 18 der Durchführung 9 eingebettete Signalpin 7 stirnseitig mit einer Verdickung 19 versehen.

Die Verdickung 19 liegt in etwa auf einer Ebene mit dem Boden 31 des Sockels 2. Hierunter wird verstanden, dass die Stirnseite der Verdickung 19 in etwa auf einer Höhe mit dem angrenzenden Boden 31 liegt.

Fig. 20 ist eine schematische Schnittansicht des in Fig. 19 dargestellten TO-Gehäuses 1, wobei das TO-Gehäuse 1 mit einem Submount 5 bestückt ist. Der Submount 5 ist koaxial zum Signalpin 7 ausgerichtet.

Weiter ragt der Submount 5 in den Bereich der Verdickung 19 hinein.

Hierdurch wird ermöglicht, dass der Signalpin 7 nicht seitlich an den Submount 5 angeschlossen wird, sondern dass die Stirnseite der Verdickung 19 als Anschlussfläche für die Leiterbahn (nicht dargestellt) des Submounts 5 dient.

Um eine elektrische Verbindung bereitzustellen, ist Lot 8 in Form einer Lotkehle eingebracht, die Lotverbindung erfolgt also entlang einer Ecke, die durch die Leiterbahn 6a, 6b des Submounts 5 und die Stirnseite der Verdickung 19 gebildet ist.

Durch die Verdickung 19, welche mit dem Boden 31 des Sockels 2 fluchtet, kann die Spaltbreite zwischen den Anschlussflächen minimiert werden.

Gegenüber einem Signalpin 7 ohne Verdickung 19 ist eine geringere Menge von Lot 8 erforderlich, so dass u.a. die Varianz des Widerstandes der Lötstelle im Hochfrequenzbereich verringert werden konnte.

Fig. 21 ist eine weitere Schnittansicht einer Ausführungsform der Erfindung.

Die Ausgestaltung der Durchführung 9 entspricht im Wesentlichen der in Fig. 12 dargestellten Ausführungsform.

Im Unterschied zu der in Fig. 19 und Fig. 20 dargestellten Ausführungsform umfasst der Signalpin 7 die Verlängerung 32, welche über die Verdickung 19 hinausragt.

Die Verdickung 19 liegt im Wesentlichen auf einer Ebene mit dem Boden 31 des angrenzenden Sockels 2.

Der auf dem Podest 4 montierte Submount 5 ragt abschnittsweise über die Verdickung 19. Wie vorstehend beschrieben, kann hierdurch die Spaltbreite der elektrischen Verbindung reduziert werden.

Im Unterschied zu dem in Fig. 19 und Fig. 20 dargestellten Ausführungsbeispiel ist aber der Submount 5 seitlich an dem Überstand 32 des Signalpins 7 angeschlossen. Der Überstand 32 bildet also eine Lötfahne, die einen seitlichen Anschluss des Submounts 5 mittels eines Lots 8 am Überstand 32 ermöglicht.

Der unter Bezugnahme auf Fig. 19 bis Fig. 21 dargestellte Signalpin 7 ist vorzugswiese entsprechend der Darstellung gemäß Fig. 13 dimensioniert, wobei bei der Ausführungsform gemäß Fig. 19 und Fig. 20 der Überstand 32 nicht vorhanden ist.

Der in dieser Ansicht schematisch dargestellt Submount 5 weist vorzugsweise stirnseitig entsprechend der Darstellung der folgenden Fig. 22 bis Fig. 24 eine Stufe 35 auf.

Fig. 22 ist eine perspektivische Drahtdarstellung einer Ausführungsform eines erfindungsgemäßen TO-Gehäuses 1.

Die Signalpins 7a, 7b sind entsprechend der in Fig. 19 und Fig. 20 dargestellten Ausführungsform derart ausgebildet, dass diese eine Verdickung 19 aufweisen, welche auf einer Ebene mit dem Boden 31 des Sockels 2 liegt.

Die koaxial zu den Signalpins 7a, 7b verlaufenden Leiterbahnen 6a, 6b des Submounts 5 sind auf die Signalpins 7a, 7b aufgesetzt und die sich so ergebende Kante ist mit einem Lot 8 verlötet, welches eine Kehle bildet.

Wie in der Detaildarstellung gemäß Fig. 23 zu erkennen, umfasst der Submount 5 stirnseitig gegenüber dem elektrischen Anschluss an den Signalpins 7a, 7b einen ausgedünnten Bereich 33.

Der Submount 5 ist also stirnseitig zumindest im Bereich der Anschlüsse dünner.

Die den Signalleiterbahnen 17a, 17b gegenüberliegende Erdleiterbahn 16a bis 16d an der Unterseite des Submounts 5 rückt so näher an die als Signalleiterbahn dienenden Leiterbahnen 6a, 6b heran, wodurch die Impedanz im Hochfrequenzbereich verringert werden kann.

Der ausgedünnte Bereich 33 kann beispielsweise durch Laser-Milling hergestellt werden.

Da sich der ausgedünnte Bereich 33 nur an der Stirnseite befindet und vorzugsweise maximal um die Dicke des Submounts 5 in der Tiefe in den Submount 5 hineinragt, wird die mechanische Stabilität des Submounts 5 nicht nennenswert beeinträchtigt.

In der Detailansicht ist weiter zu erkennen, dass die Breite des Lots 8 in etwa dem Durchmesser der Verdickungen 19 entspricht.

Fig. 24 ist eine perspektivische Ansicht nur des Submounts 5.

Gut zu erkennen ist der ausgedünnte Bereich 33 an der Stirnseite des Submounts 5. Dieser geht über eine Stufe in den dahinterliegenden restlichen Bereich des Submounts 5 über, in welchem dieser dicker ausgebildet ist. Der Submount 5 ist, einschließlich des ausgedünnten Bereiches 33, auf seiner Unterseite mit einer Erdleiterbahn beschichtet. Diese kann insbesondere als abgeschiedene Metallbeschichtung der Unterseite ausgebildet sein.

Der darstellte Submount 5 mit dem ausgedünnten Bereich 33 kann für alle Ausführungsformen der Erfindung verwendet werden, insbesondere auch für die in Fig. 21 dargestellte Variante, bei welcher der Signalpin 7 einen Überstand 32 zum seitlichen Anschluss aufweist.

Fig. 25 ist ein Graph, in dem die Reflexionsdämpfung eines Ausführungsbeispiels eines TO-Gehäuses (untere dünne Kurve) dargestellt ist, welches entsprechend der Ausführungsform gemäß Fig. 22 und Fig. 23 einen Submount 5 mit einem ausgedünnten stirnseitigen Bereich umfasst und welches Signalpins 7 mit einer Verdickung 19 aufweist, deren Stirnfläche dem Anschluss des Submounts 5 dient.

Dem gegenübergestellt ist in der oberen dicken Kurve die Reflexionsdämpfung eines TO-Gehäuses, welches diese beiden Merkmale nicht aufweist, also Signalpins ohne Verdickung aufweist, an die der Submount seitlich angeschlossen ist und bei welchem der Submount keinen ausgedünnten Bereich aufweist. Ansonsten ist dieses TO-Gehäuse aber gleich ausgebildet.

Zu erkennen ist, dass die Reflexionsdämpfung, insbesondere im Frequenzbereich zwischen 10 und 50 GHz, deutlich verbessert werden konnte. So konnte in diesem Frequenzbereich im Mittel ein um etwa -10 dB verschobene Reflexionsdämpfung erreicht werden.

Fig. 26 ist eine schematische Schnittansicht eines weiteren Ausführungsbeispiels eines TO-Gehäuses 1, bei welcher die Durchführung 9 zwei Bereiche mit unterschiedlicher Permittivität aufweist.

Innenseitig ist angrenzend zum Boden 31 in die Durchführung 9 ein vorzugsweise aus Keramik oder Glaskeramik ausgebildeter Deckel 34 eingesetzt.

Der Deckel 34 ist als Lochscheibe ausgebildet, durch die sich der Signalpin 7 erstreckt und hält das Isolationsmaterial 18 aus Glas oder Glaskeramik zurück.

Gleichzeitig hat der Deckel 34 eine höhere Permittivität εᵣ als das angrenzende Isolationsmaterial 18.

So entsteht ein lokaler Bereich mit erhöhter Kapazität.

Bei dieser Ausführungsform der Erfindung ist denkbar, den Submount (nicht dargestellt) stirnseitig mit dem Signalpin 7 zu verbinden, der in dieser Darstellung auf einer Ebene mit dem Boden 31 des Sockels 2 endet.

Ebenso ist in einer anderen Ausführungsform (nicht dargestellt) möglich, dass der Signalpin 7 in das TO-Gehäuse 1 hineinragt und seitlich mit dem Submount verbunden ist.

Fig. 27 ist eine schematische Schnittansicht einer weiteren Ausführungsform eines TO-Gehäuses 1, bei welchem die Durchführung 9 eine Stufe 35 aufweist, welche unterhalb des Bodens 31 angeordnet ist.

Durch die Stufe 35 hat die Durchführung 9 in einem oberen Bereich angrenzend an den Boden 31 einen kleineren Durchmesser.

Hierdurch kann zum einen lokal die Kapazität der Durchführung 9 erhöht werden, um den Impedanzverlauf des Signalpfades anzupassen. Gleichzeitig kann der lokal verringerte Lochdurchmesser der Durchführung zu einer besseren Genauigkeit des Füllstandes der Durchführung 9 mit Isolationsmaterial 18 dienen.

Fig. 28 bis Fig. 30 zeigen eine weitere Ausführungsform eines TO-Gehäuses 1, bei welchem die Verdickung 19 des Signalpins 7 nur teilweise in der Durchführung 9 angeordnet ist.

Fig. 28 ist eine Draufsicht auf das TO-Gehäuse 1. Der Sockel 2 des TO-Gehäuses 1 umfasst ein Podest 4, auf welchem der Submount 5 angeordnet ist.

Fig. 29 ist eine Seitenansicht. In dieser Ansicht sind insbesondere die Leiterbahnen 6a, 6b des Submounts 5 zu erkennen, über die ein optoelektronisches Bauelement (nicht dargestellt) kontaktiert werden kann.

Fig. 30 ist eine Schnittansicht entlang der Linie A-A der Fig. 29.

Der Signalpin 7 endet mit einer Verdickung 19. Der Submount 5 ist an der Stirnseite der Verdickung 19 angeschlossen. Zur Bereitstellung einer mechanisch stabilen Verbindung mit niedriger Varianz hinsichtlich der Impedanz ist zum Anschluss des Submounts 5 an dem Signalpin 7 eine Lotkehle 8 vorgesehen, die eine flächige Kontaktierung bereitstellt.

Die Verdickung 19 endet bei dieser Ausführungsform der Erfindung nicht bündig mit dem Boden des Sockels 2, sondern steht über und ragt somit in das Gehäuse hinein.

Der Zweck einer Reduzierung der Spaltbreite am Ende der Durchführung 9 wird dennoch erreicht.

Der Submount 5 ist vorzugsweise stirnseitig entsprechend der Ausführungsform gemäß Fig. 22 bis Fig. 24 ausgedünnt, weist also eine Stufe 35 auf, so dass die Dicke in einem stirnseitigen Bereich geringer ist (nicht dargestellt).

Durch die Erfindung konnte auf einfache Weise ein TO-Gehäuse 1 bereitgestellt werden, welches signifikant höhere Datenübertragungsraten ermöglicht.

### Bezugszeichenliste

- 1: TO-Gehäuse
- 2: Sockel
- 3: Kappe
- 4: Podest
- 5: Submount
- 6a, 6b: Leiterbahnen des Submount
- 7, 7a, 7b: Signalpin
- 8: Lot/Lotkehle
- 9: Durchführung
- 10: Pin
- 11: Versteifung/verdickter Bereich
- 12: Leiterplatte
- 13: Metallblock
- 14: Unterseite
- 15a,15b: Bogen
- 16a - 16d: Erdleiterbahnen
- 17a, 17b: Signalleiterbahn
- 18, 18a, 18b: Isolationsmaterial aus Glas
- 19, 19a, 19b: Verdickung des Signalpins
- 20: Durchkontaktierung
- 21: Oberseite des Sockels
- 22: nicht mit Füllmaterial aufgefüllter Bereich der Durchführung
- 23: Durchgangsloch des Sockels
- 24: Vergussmasse aus Kunststoff
- 25: Hohlraum
- 26: Bereich mit vergrößertem Durchmesser
- 27: Fenster
- 28: Laserdiode
- 29: Bond-Draht
- 30: Montagebereich
- 31: Boden
- 32: Überstand
- 33: ausgedünnter Bereich
- 34: Deckel
- 35: Stufe

## Patentansprüche

1. TO-Gehäuse (1), umfassend einen Sockel (2) mit einer Oberseite (21), welche nach Anbringen einer Kappe (3) eine Innenwand des dann hermetisch verschlossenen TO-Gehäuses (1) bildet, und einer Unterseite (14), und mit einem Montagebereich (30) für ein optoelektronisches Bauelement im Innenraum des TO-Gehäuses (1), wobei der Sockel (2) zumindest einen in einer Durchführung (9) angeordneten Signalpin (7, 7a, 7b) zum Anschluss des optoelektronischen Bauelements umfasst, der aus der Unterseite (14) herausragt, wobei eine Leiterplatte (12) im Wesentlichen koaxial an dem Signalpin (7, 7a, 7b) angebracht ist, und wobei die Leiterplatte (12) mittels zumindest eines an die Durchführung (9) angrenzenden Metallblocks (13) mit dem Sockel (2) mechanisch und elektrisch zur Bereitstellung einer Erdung verbunden ist.

2. TO-Gehäuse (1) nach dem vorstehenden Anspruch, **gekennzeichnet durch** zumindest eines der Merkmale des Metallblocks (13):
der Metallblock (13) ist als massive Platte aus Metall ausgebildet,
- der Metallblock (13) ist als Brücke ausgebildet, die sich über den in der Durchführung (9) angeordneten Signalpin (7, 7a, 7b) erstreckt.

3. TO-Gehäuse (1) nach einem der vorstehenden Ansprüche, **gekennzeichnet durch** zumindest eines der Merkmale der Leiterplatte (12):
- die Leiterplatte (12) ist als flexible Leiterplatte (12) ausgebildet,
- die Leiterplatte (12) ist unterhalb des Metallblocks (13) mit einer Versteifung (11) versehen,
- die Leiterplatte (12) ist als mehrlagige Platte ausgebildet, wobei unter einer Signalleiterbahn (17a, 17b) und/oder zwischen Signalleiterbahnen (17a, 17b) ein Erdleiter (16a, 16b) vorhanden ist,
- die Leiterplatte (12) ist angrenzend zur Unterseite (14) des TO-Gehäuses (1) verdickt ausgebildet,
- die Leiterplatte (12) weist einen verdickten mehrlagigen Bereich auf
- das TO-Gehäuse (1) umfasst zumindest zwei, insbesondere genau zwei, jeweils in einer Durchführung (9) angeordnete Signalpins (7, 7a, 7b).

4. TO-Gehäuse (1) nach einem der vorstehenden Ansprüche, **gekennzeichnet durch** zumindest eines der folgenden Merkmale:
- der Montagebereich (30) befindet sich auf einem Submount (5), der über zumindest einen Signalpin (7, 7a, 7b) kontaktiert ist,
- der Montagebereich (30) befindet sich auf einem Submount (5) welcher auf einem Podest (4) des Sockels (2) sitzt,
- der Signalpin (7, 7a, 7b) grenzt an einen Submount (5) für das optoelektronische Bauelement an, wobei der Signalpin (7, 7a, 7b) exzentrisch in der Durchführung (9) in Richtung des Submounts (5) versetzt angeordnet ist.

5. TO-Gehäuse (1) nach einem der vorstehenden Ansprüche, **gekennzeichnet durch** zumindest eines der folgenden Merkmal:
- die Durchführung (9) ist mit einem Isolationsmaterial aus Glas und/oder Glaskeramik gefüllt, wobei sich auf zumindest einer Seite der Durchführung (9) ein Bereich befindet, in welchem die Durchführung (9) nicht mit dem Isolationsmaterial (18, 18a, 18b) aus Glas und/oder Glaskeramik befüllt ist
- die Durchführung (9) ist mit einem Isolationsmaterial (18, 18a, 18b) aus Glas mit einer relativen Permittivität εᵣ (bei 18 °C und 50 Hz) von unter 6,0, vorzugsweise von unter 5,0 gefüllt.

6. TO-Gehäuse (1) nach dem vorstehenden Anspruch **dadurch gekennzeichnet, dass** in dem Bereich, in welchem das Isolationsmaterial (18, 18a, 18b) aus Glas und/oder Glaskeramik nicht vorhanden ist, der Signalpin (7, 7a, 7b) eine Verdickung (19, 19a, 19b) aufweist und/oder der Bereich mit einem Kunststoff, insbesondere mit einem Epoxidharz, aufgefüllt ist.

7. Set zur Bereitstellung eines TO-Gehäuses (1) nach einem der vorstehenden Ansprüche, umfassend zumindest einen Sockel (2) mit zumindest einem in einer Durchführung (9) angeordneten Signalpin (7, 7a, 7b) sowie einen Metallblock (13) zum Verbinden des Sockels (2) mit einer Leiterplatte (12).

8. Verfahren zur Montage eines TO-Gehäuses (1) nach einem der vorstehenden Ansprüche, wobei zunächst der zumindest eine Signalpin (7, 7a, 7b) mit der Leiterplatte (12) verbunden wird und im Anschluss der Metallblock (13) mit Sockel (2) und Leiterplatte (12) zur Bereitstellung einer Erdverbindung verbunden wird.

9. Einrichtung zur Datenübertragung mit einer Datenübertragungsrate von zumindest 100 GBit/s pro Wellenlänge, beinhaltend zumindest ein TO-Gehäuse (1) nach mindestens einem der Ansprüche 1 bis 14.

10. TO-Gehäuse (1), insbesondere nach einem der vorstehenden Ansprüche, umfassend einen Sockel (2) mit einem Montagebereich (30) für ein optoelektronisches Bauelement, wobei der Sockel (2) zumindest einen in einer Durchführung (9) angeordneten Signalpin (7, 7a, 7b) zum Anschluss des optoelektronischen Bauelements umfasst, und wobei der Signalpin (7, 7a, 7b) eine Verdickung (19, 19a, 19b) umfasst, welche zumindest abschnittsweise in der Durchführung (9) angeordnet ist.

11. TO-Gehäuse (1) nach dem vorstehenden Anspruch, **gekennzeichnet durch** zumindest eines der folgenden Merkmale:
- die Verdickung (19, 19a, 19b) liegt im Wesentlichen in einer Ebene mit dem an die Durchführung (9) angrenzenden Boden (31) des Sockels (2)
- der Signalpin (7, 7a, 7b) weist eine Anschlussfläche für das optoelektronische Bauelement auf, welche durch eine Stirnseite der Verdickung (19, 19a, 19b) gebildet wird.

12. TO-Gehäuse (1) nach einem der vorstehenden Ansprüche, **dadurch gekennzeichnet, dass** der Signalpin (7, 7a, 7b) mit einem elektrisch leitenden Material, insbesondere mit einem Lot (8), mit einem Submount (5) verbunden ist.

13. TO-Gehäuse (1) nach dem vorstehenden Anspruch, **dadurch gekennzeichnet, dass** der Signalpin (7, 7a, 7b) mit einer Seitenwand, insbesondere der Seitenwand eines an die Verdickung (19, 19a, 19b) angrenzenden Überstands, mit dem Submount (5) verbunden ist.

14. TO-Gehäuse (1) nach einem der vorstehenden Ansprüche, **dadurch gekennzeichnet, dass** die Durchführung (9) mit einem Isolationsmaterial (18, 18a, 18b), insbesondere umfassend Glas und/oder Glaskeramik, befüllt ist, wobei sich das Isolationsmaterial (18, 18a, 18b) auch um die Verdickung (19, 19a, 19b) erstreckt.

15. TO-Gehäuse (1) nach dem vorstehenden Anspruch, **dadurch gekennzeichnet, dass** sich zumindest eine Leiterbahn (6a, 6b) eines Submounts (5) koaxial zum Signalpin (7, 7a, 7b) erstreckt.

16. TO-Gehäuse (1), insbesondere nach einem der vorstehenden Ansprüche, umfassend einen Sockel (2) mit einem Montagebereich (30) für ein optoelektronisches Bauelement, wobei das TO-Gehäuse (1) einen Submount (5) für das optoelektronische Bauelement umfasst, wobei der Sockel (2) zumindest einen in einer Durchführung (9) angeordneten Signalpin (7, 7a, 7b) zum Anschluss des optoelektronischen Bauelements umfasst, und wobei sich eine koaxial zum Signalpin (7, 7a, 7b) erstreckende Leiterbahn (6a, 6b) des Submounts (5) an einer Stirnseite des Signalpins (7, 7a, 7b) angeschlossen, insbesondere angelötet, ist.

17. TO-Gehäuse (1) nach einem der drei vorstehenden Ansprüche, **dadurch gekennzeichnet, dass** der Submount (5) zwei Leiterbahnen (6a, 6b) umfasst, welche sich koaxial zu zwei Signalpins (7, 7a, 7b) erstrecken.

18. TO-Gehäuse (1), insbesondere nach einem der vier vorstehenden Ansprüche, umfassend einen Sockel (2) mit einem Montagebereich (30) für ein optoelektronisches Bauelement, wobei das TO-Gehäuse (1) einen Submount (5) für das optoelektronische Bauelement umfasst, wobei der Sockel (2) zumindest einen in einer Durchführung (9) angeordneten Signalpin (7, 7a, 7b) zum Anschluss des optoelektronischen Bauelements umfasst, und wobei der Submount (5) stirnseitig zumindest unterhalb zumindest einer Leiterbahn (6a, 6b) einen ausgedünnten Bereich aufweist, welcher mit einer Erdleiterbahn (16a, 16b) versehen ist.

19. TO-Gehäuse (1) nach einem der fünf vorstehenden Ansprüche, **dadurch gekennzeichnet, dass** der Submount (5) sich zumindest abschnittsweise über eine Verdickung (19, 19a, 19b) des Signalpins (7, 7a, 7b) erstreckt.

20. TO-Gehäuse (1) nach einem der vorstehenden Ansprüche, **gekennzeichnet durch** zumindest eines der folgenden Merkmale:
- die Durchführung (9) umfasst ein erstes Isolationsmaterial (18, 18a, 18b), welches Glas- und/oder Glaskeramik, wobei im Bereich des Bodens (31) des Sockels (2) angrenzend an das Isolationsmaterial (18, 18a, 18b) ein weiteres Isolationsmaterial (18, 18a, 18b) angeordnet ist, welches eine relative Permittivität εᵣ (bei 18 °C und 50 Hz) hat, die höher ist als die des ersten Isolationsmaterials (18, 18a, 18b)
- die Durchführung (9) weist auf zumindest einer Seite einen Deckel (34) aus dielektrischem Material auf,
die Durchführung (9) weist unterhalb eines Bodens (31) des Sockels (2) eine Stufe auf.

21. Einrichtung zur Datenübertragung mit einer Datenübertragungsrate von zumindest 100 GBit/s pro Wellenlänge, beinhaltend zumindest ein TO-Gehäuse (1) nach einem der vorstehenden Ansprüche.
